# EUROPEAN PATENT APPLICATION

(11) **EP 4 152 375 A1**
(43) Date of publication of application: **22.03.2023**
(21) Application number: 21822556.3
(22) Date of filing: 10.06.2021
(51) Int. Cl.: H01L 23/31, H01L 23/367, H01L 25/07, H01L 23/48, H01L 23/535

(54) **SEMICONDUCTOR APPARATUS, AND ELECTRONIC DEVICE COMPRISING SAME**

(30) Priority: 11.06.2020 CN 202010531248
(71) Applicant: Huawei Technologies Co., Ltd., Longgang District, Shenzhen, Guangdong 518129 (CN)
(72) Inventor: XU, Yan, Shenzhen, Guangdong 518129 (CN); JI, Zhongli, Shenzhen, Guangdong 518129 (CN); CHEN, Yu, Shenzhen, Guangdong 518129 (CN)
(74) Representative: Isarpatent
(86) International application number: PCT/CN2021/099498
(87) International publication number: WO 2021/249509

(57) **Abstract**

Embodiments disclosed in this application relate to a semiconductor apparatus and an electronic device including the semiconductor apparatus. The semiconductor apparatus includes: a first semiconductor layer; a second die; a thermally conductive layer, where the thermally conductive layer is stacked with the first semiconductor layer and the second die, is located between the first semiconductor layer and the second die, and is configured to conduct heat from the first semiconductor layer and/or heat from the second die at the thermally conductive layer, and a coefficient of thermal conductivity of the thermally conductive layer in a horizontal direction is greater than or equal to a coefficient of thermal conductivity in a vertical direction; and a first conductive pillar, where the first conductive pillar penetrates through the thermally conductive layer, so that the first semiconductor layer and the second die are electrically interconnected by using the first conductive pillar, the first conductive pillar is electrically insulated from the thermally conductive layer, an extension direction of the first conductive pillar is the vertical direction, and the coefficient of thermal conductivity of the thermally conductive layer in the horizontal direction is greater than a coefficient of thermal conductivity of the first semiconductor layer. The thermally conductive layer is disposed, and such a semiconductor device can eliminate a local hot spot effect.

## Description

### TECHNICAL FIELD

Embodiments disclosed in this application relate to the field of semiconductor technologies, and more specifically, to a semiconductor apparatus and an electronic device that includes the semiconductor apparatus.

### BACKGROUND

In a packaging process of an integrated circuit, a semiconductor die may be bonded to another component such as an interconnection layer or a package substrate, and a formed package structure is referred to as a three-dimensional integrated circuit (3D IC). Heat dissipation is a challenge in the 3D IC.

In a typical 3D IC (for example, a chip-on-wafer-on-substrate (Chip-on-Wafer-on-Substrate, CoWoS) package), heat may accumulate in an inner region at a bottom of a die stack, resulting in a significant local temperature peak (which is also referred to as a hot spot). In addition, a hot spot caused due to heat generated by a high power consumption die may cause a thermal crosstalk problem to a surrounding die, and consequently adverse impact may be exerted on performance of the surrounding die and reliability of the entire 3D IC package. This local hot spot problem described by using the 3D IC as an example also widely exists in other semiconductor die package structures (for example, a 2.5D IC package).

### SUMMARY

This application provides a semiconductor apparatus, to resolve a local hot spot problem in the semiconductor apparatus to some extent. In addition, this application further provides an electronic device. The electronic device includes the semiconductor apparatus.

According to a first aspect disclosed in this application, a semiconductor apparatus is provided. The semiconductor apparatus includes: a first semiconductor layer; a second die; a thermally conductive layer, where the thermally conductive layer is stacked with the first semiconductor layer and the second die, is located between the first semiconductor layer and the second die, and is configured to conduct heat from the first semiconductor layer and/or heat from the second die at the thermally conductive layer, and a coefficient of thermal conductivity of the thermally conductive layer in a horizontal direction is greater than or equal to a coefficient of thermal conductivity in a vertical direction; and a first conductive pillar, where the first conductive pillar penetrates through the thermally conductive layer, so that the first semiconductor layer and the second die are electrically interconnected by using the first conductive pillar, the first conductive pillar is electrically insulated from the thermally conductive layer, an extension direction of the first conductive pillar is the vertical direction, and the coefficient of thermal conductivity of the thermally conductive layer in the horizontal direction is greater than a coefficient of thermal conductivity of the first semiconductor layer.

The first semiconductor layer and/or the second die may generate heat in a working process, and the heat may be unevenly distributed in the horizontal direction. The thermally conductive layer is stacked with the first semiconductor layer and the second die, and the coefficient of thermal conductivity of the thermally conductive layer in the horizontal direction is greater than or equal to the coefficient of thermal conductivity in the vertical direction. Therefore, the heat can be spread in the horizontal direction, to achieve a heat spreading effect in the horizontal direction, so as to alleviate or eliminate a local hot spot effect. In addition, the first conductive pillar is disposed at the thermally conductive layer, to electrically interconnect the first semiconductor layer and the second die. The thermally conductive layer is usually a conductive material. Therefore, when the thermally conductive layer is electrically insulated from the first conductive pillar, an electrical function of the first conductive pillar is not affected, to ensure that the semiconductor apparatus can work normally.

In some embodiments, there are a plurality of vias at the thermally conductive layer, and one or more first conductive pillars penetrate through one of the vias.

A quantity of vias and a quantity of conductive pillars may be determined based on a specific requirement of a die. Dies are usually interconnected by using a plurality of vias. A size of the conductive pillar is usually determined based on a semiconductor manufacturing process, a size and performance of the die, and the like. It is easier to manufacture a via with a large aperture at lower costs. Therefore, to reduce manufacturing costs of the thermally conductive layer, a via in which a plurality of conductive pillars can be accommodated may be used. In some cases, to improve heat spreading performance, a relatively small via may be manufactured, to retain the thermally conductive layer as much as possible. In other words, only one conductive pillar is accommodated in one via.

In some embodiments, the thermally conductive layer is bonded to the first semiconductor layer.

The bonding connection is a connection that is implemented without using adhesive or a welding layer and that can significantly reduce thermal resistance between the thermally conductive layer and the first semiconductor layer. Therefore, the heat can be quickly spread in the horizontal direction through the thermally conductive layer, to improve the heat spreading effect.

In some embodiments, the semiconductor apparatus further includes an insulating material, the insulating material covers a surface of the thermally conductive layer, and the first conductive pillar further penetrates through the insulating material.

The insulating material covers the surface of the thermally conductive layer, and therefore a conductive path between the thermally conductive layer and another element is cut off, and accordingly an electrical operation of the semiconductor apparatus is not affected.

In some embodiments, the semiconductor apparatus further includes an insulation layer that is disposed to at least partially surround the first conductive pillar and extend along the first conductive pillar and that is configured to isolate the first conductive pillar from the thermally conductive layer to implement electrical insulation.

The insulation layer is disposed to surround the first conductive pillar, so that the first conductive pillar can be electrically insulated from the thermally conductive layer.

In some embodiments, the semiconductor apparatus further includes a filler material that is disposed at the thermally conductive layer and that is located between the thermally conductive layer and the insulation layer.

In a process of drilling the thermally conductive layer, to reduce costs, vias with relatively large apertures may be manufactured. Therefore, the filler material is required to fill these vias, to reduce difficulty of forming the conductive pillar.

In some embodiments, the filler material is compatible with a through silicon via (TSV) process, and the through silicon via refers to an electrical interconnection implemented by filling a via of a silicon wafer with a conductive material.

The filler material is compatible with the TSV process. Therefore, a process of punching the filler material may be implemented by using a known semiconductor manufacturing process, to implement good process compatibility.

In some embodiments, the first semiconductor layer is a first die or a first interconnection layer.

In some embodiments, when the first semiconductor layer is a first die, the first conductive pillar further penetrates through the first die.

In some embodiments, the semiconductor apparatus further includes a third semiconductor layer that is disposed on a side that is of the first semiconductor layer and that is far away from the thermally conductive layer, and the third semiconductor layer is electrically coupled to the conductive pillar.

In some embodiments, the thermally conductive layer includes a carbon-based material, a metal material, or a combination thereof.

In some embodiments, the carbon-based material includes a graphene film.

In some embodiments, a thickness of the thermally conductive layer is at least 5 µm.

According to a second aspect, an electronic device is provided, and includes the semiconductor apparatus according to the first aspect.

In some embodiments, the electronic device includes a switch, a router, a mobile phone, a personal digital assistant (PDA), a navigation device, a set-top box, a music player, or a video player.

According to a third aspect, a heat spreader is provided, and includes: a carbon-based material layer, where a coefficient of thermal conductivity of the carbon-based material layer in a horizontal direction is greater than or equal to a coefficient of thermal conductivity in a vertical direction; and a first non-metal pillar that penetrates through the carbon-based material layer, where an extension direction of the first non-metal pillar is the vertical direction, the first non-metal pillar is made of an insulating material or a semiconductor material, and a part that is of the first non-metal pillar and that is in contact with the carbon-based material layer is an insulating material.

The heat spreader may be used in a semiconductor package structure, and is configured to spread heat for a die in the semiconductor package structure. An electrical interconnection structure is allowed to be manufactured in the first non-metal pillar. Therefore, an electrical property of the semiconductor die is not affected while heat is spread for the semiconductor die. The part that is of the first non-metal pillar and that is in contact with the carbon-based material layer is an insulating material. Therefore, if a conductive pillar is formed in the first non-metal pillar, the insulating material may electrically insulate the conductive pillar.

In some embodiments, roughness of a surface of the thermally conductive layer is less than or equal to 1 nm.

In some embodiments, a diameter of the first non-metal pillar is between 10 µm and 40 µm.

The summary is provided to describe selection of concepts in a simplified form, and the concepts are further described in the following specific implementations. The summary is not intended to identify key features or main features disclosed in this application, and is not intended to limit the scope disclosed in this application.

### BRIEF DESCRIPTION OF DRAWINGS

The foregoing and other objectives, features, and advantages disclosed in this application become more apparent by describing, with reference to the accompanying drawings, in more detail the example embodiments disclosed in this application. In the example embodiments disclosed in this application, same reference numerals usually represent same components.
FIG. 1A is a cross-sectional view of a semiconductor apparatus according to some implementations disclosed in this application;
FIG. 1B is a cross-sectional view of a semiconductor apparatus according to some implementations disclosed in this application;
FIG. 2 is a cross-sectional view of a semiconductor apparatus for which a CoWoS package is used according to a conventional technology;
FIG. 3A is a cross-sectional view of a semiconductor apparatus for which a CoWoS package is used according to some implementations disclosed in this application;
FIG. 3B is an enlarged cross-sectional view of a part of the semiconductor apparatus shown in FIG. 3A;
FIG. 4 is a schematic diagram of a simulation structure according to an embodiment disclosed in this application;
FIG. 5A to FIG. 5Q are respectively schematic diagrams of stages in a process of manufacturing a semiconductor apparatus according to a first embodiment disclosed in this application;
FIG. 6A and FIG. 6B are separately schematic diagrams of a first variant of a manufacturing method according to a first embodiment disclosed in this application;
FIG. 7A to FIG. 7D are separately schematic diagrams of a second variant of a manufacturing method according to a first embodiment disclosed in this application;
FIG. 8A to FIG. 8H are respectively schematic diagrams of several stages in a process of manufacturing a semiconductor apparatus according to a second embodiment disclosed in this application;
FIG. 9A to FIG. 9C are respectively schematic diagrams of several stages in a process of manufacturing a semiconductor apparatus according to a third embodiment disclosed in this application;
FIG. 10A to FIG. 10I are respectively schematic diagrams of several stages in a process of manufacturing a semiconductor apparatus according to a fourth embodiment disclosed in this application;
FIG. 11A to FIG. 1 1J are respectively schematic diagrams of several stages in a process of manufacturing a semiconductor apparatus according to a fifth embodiment disclosed in this application; and
FIG. 12 is a flowchart of a method for manufacturing a semiconductor apparatus according to some implementations disclosed in this application.

The various feature parts shown in the accompanying drawings may not be drawn to scale in accordance with common practice. Therefore, for clarity, sizes of the various feature parts may be randomly extended or reduced. In addition, all components of a given system, method, or device may not be depicted in some accompanying drawings. Finally, in the entire specification and the accompanying drawings, similar reference numerals may be used to represent similar feature parts.

### DESCRIPTION OF EMBODIMENTS

The embodiments in this application are described below in more detail with reference to the accompanying drawings. The term "include" and a variant thereof used in this specification represent non-exclusive inclusion, in other words, represent "including but not limited to". Unless specifically stated, the term "or" means "and/or". The term "and/or" in this specification describes only an association relationship for describing associated objects and represents that three relationships may exist. For example, A and/or B may represent the following three cases: Only A exists, both A and B exist, and only B exists. The term "based on" means "at least partially based on". The terms "an example embodiment" and "an embodiment" mean "at least one example embodiment". The term "another embodiment" means "at least one another embodiment". The terms "first", "second", and the like may refer to different objects or a same object. Other explicit and implied definitions may be further included below.

Any reference to a direction or an orientation is intended only for ease of description, and is not intended to limit the scope of the present invention in any manner. For example, related terms such as "lower", "upper", "horizontal", "vertical", "above", "below", "upward", "downward", "top", "bottom", and derivatives (for example, "horizontally", "up", and "down") thereof are used in the description to refer to orientations described below or shown in the accompanying drawings. These related terms are intended only for ease of description, and do not require an apparatus to be constructed or operated in a particular orientation.

A semiconductor apparatus for alleviating or eliminating a local hot spot problem and a method for manufacturing a semiconductor apparatus are provided according to various example embodiments. Herein, an intermediate stage of forming the semiconductor apparatus is shown, and a plurality of embodiments and variants thereof are described. In various views and example embodiments, similar reference numerals are used to represent similar elements.

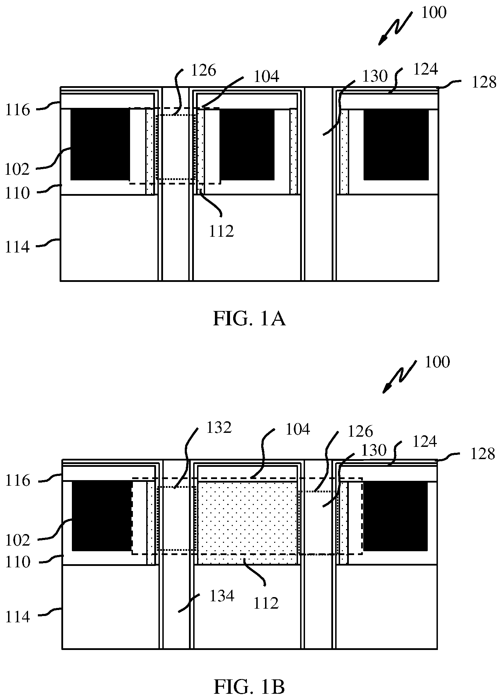

FIG. 1A is a cross-sectional view of a semiconductor apparatus 100. The semiconductor apparatus 100 includes a first semiconductor layer 114, for example, a first die (logic die or memory die) or a first interconnection layer (interposer). A thermally conductive layer 102 is stacked with the first semiconductor layer 114, and by virtue of a heat-conducting property of the thermally conductive layer 102, it is allowed to conduct heat from either side of the thermally conductive layer 102 inside the thermally conductive layer 102 (it should be noted that the first semiconductor layer 114 is located on one side of the thermally conductive layer 102, and the other side of the thermally conductive layer 102 faces away from the first semiconductor layer 114). In an example shown in FIG. 1A, it is allowed to conduct heat from a part above and/or heat from a part below the thermally conductive layer 102 inside the thermally conductive layer 102. For convenience, orientations of the components are described below with reference to the accompanying drawings. However, as described above, these orientation-related terms are intended only for ease of description, and do not require an apparatus to be constructed or operated in a particular orientation.

For example, a second die may be disposed above the thermally conductive layer 102, the first semiconductor layer 114 may include the first die, a third semiconductor layer may be disposed below the first semiconductor layer 114, and the third semiconductor layer may include the third die. Therefore, there may be heat sources above and below the thermally conductive layer 102. A coefficient of thermal conductivity of the thermally conductive layer 102 in a horizontal direction may be greater than or equal to a coefficient of thermal conductivity in a vertical direction, to facilitate heat conduction in the horizontal direction. In addition, the coefficient of thermal conductivity of the thermally conductive layer 102 in the horizontal direction is greater than a coefficient of thermal conductivity of the first semiconductor layer 114. The heat from the part above and/or the heat from the part below the thermally conductive layer 102 may be distributed as evenly as possible on an entire plane of the thermally conductive layer 102 by using the thermally conductive layer 102. In this way, a local hot spot problem in the semiconductor apparatus can be alleviated or eliminated.

The thermally conductive layer 102 and the first semiconductor layer 114 may be bonded, for example, are bonded without using adhesive or a welding layer or fastened through bonding by using a wafer bonding process or a surface activated bonding (SAB) process. In this way, thermal resistance between the thermally conductive layer 102 and the first semiconductor layer 114 can be significantly reduced, and therefore a hot spot at the first semiconductor layer 114 can be quickly spread through the thermally conductive layer 102.

A conductive pillar 130 penetrates through the thermally conductive layer 102, so that the second die above the thermally conductive layer 102 is electrically interconnected with the first semiconductor layer 114. In an example, an electrical contact of the first semiconductor layer 114 may be disposed on an upper surface, to form a conductive interconnection with the conductive pillar 130. In another example, an electrical contact of the first semiconductor die 114 may be disposed on a lower surface of the first semiconductor layer 114, and the conductive pillar 130 may penetrate through the first semiconductor layer 114 and the thermally conductive layer 102, to electrically interconnect the second die above the thermally conductive layer 102 and the first semiconductor layer 114. In still another example, when the third semiconductor layer is disposed below the first semiconductor layer 114, the conductive pillar 130 may penetrate through the first semiconductor layer 114 and the thermally conductive layer 102, to vertically interconnect the second die above the thermally conductive layer 102 and the third semiconductor layer below the first semiconductor layer 114.

The conductive pillar 130 is electrically insulated from the thermally conductive layer 102, to implement insulation isolation. For example, electrical insulation may be implemented by disposing one or more dielectric layers between the conductive pillar 130 and the conductive layer 102. This depends on a specific process. A thickness of the dielectric layer may be tens of nanometers. In some examples, to reduce difficulty of punching the thermally conductive layer 102, holes with relatively large apertures are manufactured at the thermally conductive layer 102. In this case, these holes may be filled with a filler material compatible with a through silicon via (TSV) process, for example, silicon or silicon dioxide. A through silicon via refers to an electrical interconnection implemented by filling a via of a silicon wafer with a conductive material. This structure is compatible with a 3D or 2.5D IC package or the like, and therefore is very convenient for application to a related field. The conductive pillar 130 may include a barrier layer, a seed layer, and a through conductor (for example, copper). This may be implemented by using the TSV process. It should be understood that the term "conductive pillar" does not mean that a cross section is in a round shape. For example, the cross section may alternatively be in various suitable shapes such as an elliptic shape and a polygonal shape. In addition, the term "conductive pillar" does not mean that there is a same cross-sectional shape or size in a length direction of the entire conductive pillar. For example, different cross sections of the conductive pillar in an extension direction (for example, the vertical direction in FIG. 1A) of the conductive pillar may have different shapes, sizes, or the like.

For example, a shape of the conductive pillar is associated with a shape of the hole, and the shape of the hole is affected by different punching processes. For example, in a laser punching process, the shape of the hole is usually a structure in which there is a relatively large size at an upper part and a relatively small size at a lower part. In a TSV Bosch process, the hole is generally in a cylindrical shape. During structuring of the conductive pillar, there may further be a hole in the conductive pillar due to a process limitation.

The thermally conductive layer 102 may be made of various thermally conductive materials, for example, a carbon-based material, a metal material, or a combination thereof, especially a graphene film. A thickness of the thermally conductive layer 102 may be at least 5 µm, for example, is between 5 µm and 1000 µm; for another example, is between 10 µm and 300 µm; or for still another example, is between 20 µm and 100 µm, and especially, is between 30 µm and 60 µm. In a conventional semiconductor manufacturing process, a functional layer of the semiconductor apparatus is usually manufactured by using a thin film deposition process such as chemical vapor deposition (CVD) or a thin film synthesis process, and a thicknesses of a thin film formed by using these semiconductor processes is usually at a nanometer level. The thermally conductive layer 102 with a relatively large thickness is used. Therefore, in this implementation disclosed in this application, a good heat spreading effect can be achieved, and a local hot spot effect can be better eliminated. An in-plane coefficient of thermal conductivity of the thermally conductive layer 102 may be greater than 600 W/mk. When the graphene-based film is used, the in-plane coefficient of thermal conductivity may be greater than 1000 W/mk or even greater than 1200 W/mk .

The graphene film is formed by spirally stacking a plurality of graphene layers. Unlike graphite, graphene is formed through regular AB stacking (half of carbon atoms at a graphene layer are located on another atom of a lower graphene layer, and the other half of the carbon atoms are located in a center of a hexagon that includes carbon atoms at the lower grapheme layer). For example, the graphene film may be made of a graphene nano sheet, for example, may be made of a graphene nano sheet that has a thickness less than 5 nm and a plane size that is between 1 micron and 100 microns. The graphene film may further be combined with other materials, for example, combined with materials such as Cu, SiC, Si, SiOz, and Al₂O₃, to implement higher strength while maintaining a high in-plane coefficient of thermal conductivity, and match a process of manufacturing a via at the thermally conductive layer 102. For example, a combination process may be to deposit reinforced materials such as a metal, non-metal, or metal/non-metal oxide, a nitride, a carbide, and a fluoride on a surface of and inside the graphene film through CVD. Alternatively, a combination process may be to infiltrate metal such as Al and Cu on a surface of and inside the graphene film under a high temperature and high pressure. It should be understood by a person skilled in the art that the graphene film may be combined with other materials by using another suitable process.

The graphene film has excellent in-plane thermal conductivity. For example, an in-plane coefficient of thermal conductivity of the graphene film may be between 1500 W/mk and 1700 W/mk. Therefore, heat can be effectively conducted on a plane of the graphene film. However, the material of the thermally conductive layer 102 is not limited to the graphene-based film, and may alternatively be made of a graphene-based composite film such as a graphite/metal composite film, or may be made of a graphite film, a graphite/metal composite film, a metal/carbon composite film, even a copper alloy film, or the like. In these materials, the graphene film has a higher in-plane coefficient of thermal conductivity, and therefore is more suitable for conducting heat on the plane of the thermally conductive layer 102, to alleviate or eliminate a local hot spot problem.

Most of thermally conductive materials are also conductive materials. Therefore, the semiconductor apparatus 100 may further include an insulating material that covers a surface of the thermally conductive layer 102, to implement insulation isolation. The surface of the thermally conductive layer 102 not only includes an upper surface and a lower surface, but also includes a side surface in the via. The insulating material may include different structures based on different manufacturing processes. For example, in the example shown in FIG. 1A, the insulating material includes a first insulation layer 110 and a second insulation layer 116. The first insulation layer 110 is disposed on the lower surface and the side surface of the thermally conductive layer 102, and the second insulation layer 116 is disposed on the upper surface of the thermally conductive layer 102. There are these insulation layers, to avoid conductive coupling of the thermally conductive layer 102 to components in the semiconductor apparatus 102, so as to avoid a damage to an electrical property of the semiconductor apparatus 102. These insulation layers may be made of low-dielectric insulating materials that have properties such as temperature resistance that can meet a subsequent semiconductor manufacturing process. Optional materials include at least one of silicon nitride, silicon carbide, silicon oxide, silicon oxycarbide, fluorinated silicon glass, carbon-doped silicon oxide, and polymer. Each of the first insulation layer 110 and the second insulation layer 116 may include a plurality of material layers, for example, a passivation layer, a barrier layer, and a dielectric layer, and may be manufactured by using a physical deposition or chemical deposition method.

In addition, as shown in FIG. 1A, an insulation layer 128 at least partially surrounds the conductive pillar 130, and extends along the conductive pillar 130, and is configured to electrically insulate the conductive pillar 130 from the thermally conductive layer 102. The conductive pillar 130 may be disposed in a first via 126. The first via 126 may penetrate through the first semiconductor layer 114, the first insulation layer 110, the thermally conductive layer 102, the second insulation layer 116, and the like. The insulation layer 128 is formed on a sidewall of the first via 126. An insulating material forming the insulation layer 128 may be at least one of silicon oxide, silicon nitride, silicon carbide, silicon oxycarbide, fluorinated silicon glass, carbon-doped silicon oxide, and polymer. The insulation layer 128 may include a plurality of material layers, for example, a passivation layer, a barrier layer, and a dielectric layer, and may be manufactured by using a physical deposition or chemical deposition method. It should be understood that a dashed-line box represents only a horizontal range of the first via 126.

In some embodiments, the semiconductor apparatus 100 may further include a second via 104. The second via 104 penetrates through at least the thermally conductive layer 102, and an aperture size of the second via 104 is greater than an aperture size of the first via 126, to surround the first via 126. The second via 104 may lower a process requirement for manufacturing the semiconductor apparatus 100. For example, the second via 106 with a relatively large size lowers an alignment requirement that exists when the first via 126 is formed, to help increase a yield and reduce manufacturing costs.

Optionally, the semiconductor apparatus 100 may further include a filler material 112, and the filler material 112 is disposed between the thermally conductive layer 102 and the insulation layer 128. The second via 104 may not be fully filled in a process of forming the insulation layer through deposition or the like. Therefore, the filler material 112 may be formed to fill the second via 104. The filler material 112 may be an insulating material (for example, silicon oxide), a semiconductor material (for example, silicon), or a combination thereof. The filler material 112 is usually compatible with the through silicon via (TSV) process, and therefore it is convenient to manufacture the first via 126. A through silicon via refers to an electrical interconnection implemented by filling a via of a silicon wafer with a conductive material. Optionally, the semiconductor apparatus 100 may further include an insulation layer 124. The insulation layer 124 may implement a passivation or protection function in a manufacturing process.

As described above, the semiconductor apparatus 100 may be compatible with various packaging processes. For example, the semiconductor apparatus 100 may be applied to a 3D or 2.5D IC package. For example, the first semiconductor layer 114 may be a first die, a second die may be disposed above the semiconductor apparatus 100, and the second die may be electrically coupled to the conductive pillars 130. In this way, the first die and the second die may be vertically interconnected by using a TSV. For example, the first die may have a thickness of 55 µm, may be made of a silicon-based material, and may have a coefficient of thermal conductivity that approximates to 90 W/mK. It should be understood that the foregoing parameters are provided only as examples, and may be adaptively modified based on a specific application.

In addition, the third semiconductor layer may be disposed below the first semiconductor layer 114, and the third semiconductor layer may be a third die or an interconnection layer. For example, the third semiconductor die may be electrically coupled to the conductive pillar 130 by using a bump or a solder ball, so as to be interconnected with the second die or another die above the second die. In a specific example, a high bandwidth memory (HBM) die stack includes a stack of a bottom-layer die and a plurality of core dies above the bottom-layer die. The bottom-layer die may be implemented as the first semiconductor layer 114 shown in FIG. 1A, and the core die may be disposed above a structure shown in FIG. 1A.

It should be understood that the semiconductor apparatus 100 is not limited to being implemented in an application in which there is an interconnection layer. Therefore, the semiconductor apparatus 100 may also be applied to a 2.5D IC package or a 3D IC package in which there is no interconnection layer, for example, applied to improving in-plane heat spreading capabilities of a plurality of layers of dies in an integrated fan-out (INFO) package.

FIG. 1B is a cross-sectional view of a semiconductor apparatus 100 according to some implementations disclosed in this application. A difference from FIG. 1A is that in FIG. 1B, a second via 104 has a larger aperture size, so that a first via 126 and a third via 132 can be accommodated. A second conductive pillar 134 is disposed in the third via 132, and is surrounded by the second via 104. It should be understood that more than two vias may be formed in the second via 104. Other parts in FIG. 1B are basically the same as those in FIG. 1A. Details are not described herein. In comparison with the semiconductor apparatus 100 shown in FIG. A, in the semiconductor apparatus 100 shown in FIG. 1B, requirements on a size, a shape, and the like of the second via 104 are further lowered, to reduce technical difficulty and costs of punching. In addition, in addition to a deposition process, a coating process may be allowed to be used to form a filler material, to significantly reduce costs.

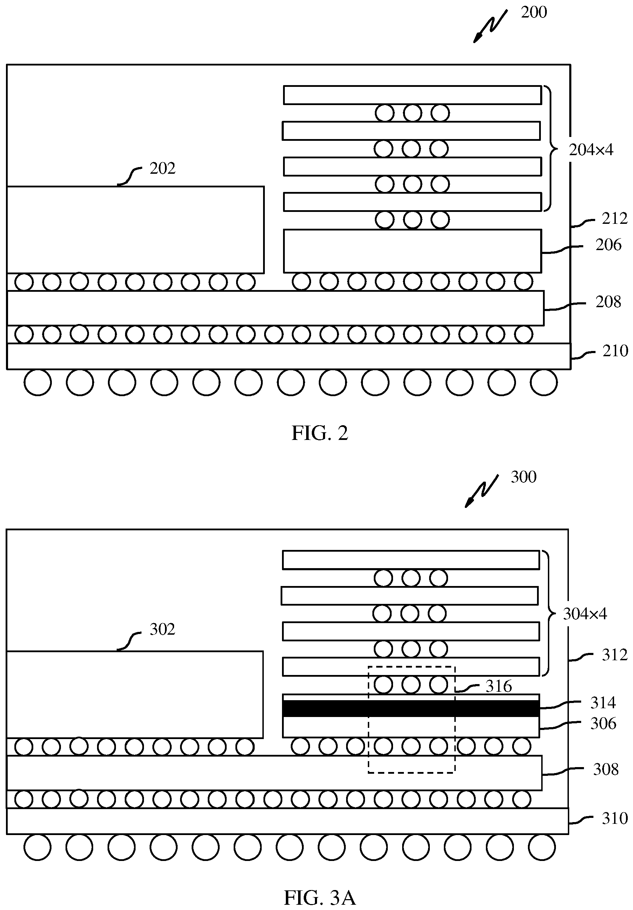

The semiconductor apparatus 100 may be applied to various electronic devices, especially communications devices, for example, a switch, a router, a mobile phone, a personal digital assistant (PDA), a navigation device, a set-top box, a music player, and a video player. In addition, the semiconductor apparatus 100 may be compatible with various different package types, for example, a CoWoS package and an INFO package. Applications of the semiconductor apparatus 100 according to some implementations disclosed in this application are described below with reference to a specific application. FIG. 2 is a cross-sectional view of a semiconductor apparatus 200 for which a CoWoS package is used according to a conventional technology. In a CoWoS packaging technology, a logic die and a memory die may be integrated into a same die package. As shown in FIG. 2, the semiconductor apparatus 200 includes a controller 202, a core die 204, and a bottom-layer die 206. There are four core dies 204. It should be understood that more or fewer core dies 204 may be used. The core dies 204 and the bottom-layer die 206 form a multi-layer memory die stack, for example, a high bandwidth memory (HBM) die stack.

The controller 202 and the bottom-layer die 206 are disposed side by side at an interconnection layer 208, and the interconnection layer 208 is disposed on a package substrate 210. A packaging material 212 packages these components, and forms an external contact on the package substrate 210, to form a die package. A physical layer (PHY) interface may be disposed on the controller 202 and the bottom-layer die 206, to allow data communication between dies.

As described above, there is a local hot spot problem in a 3D IC (for example, an HBM die), and die overheating or overtemperature may become one of key problems in subsequent heat dissipation of a 3D IC die. For example, a junction temperature specification of an HBM die that uses a DRAM process is only 95 degrees, which is significantly less than a junction temperature specification 105 degrees of a surrounding CMOS die. After a plurality of layers of HBM dies are stacked, heat of a bottom-layer die cannot be effectively conducted, and the bottom-layer die becomes a bottleneck in heat dissipation of the die.

A main reason for overheating of the HBM die is that a heat spreading capability of a silicon-based die is not high enough. A four-layer second-generation high bandwidth memory (HBM2) die stack is used as an example. In this case, a difference between a highest temperature and a lowest temperature of a local hot spot in a bottom die may be 24°C.

Existing mainstream measures for cooling the HBM die in the industry include disposing more dummy thermally conductive solder balls, using a hybrid bonding process with higher interconnection density, and the like. In these solutions, a thermal conductivity area between stacked HBM dies is increased to improve interlayer thermal resistance. In this way, impact of heat accumulation on temperature rise of the bottom die can be alleviated. However, a case in which a local hot spot problem in the HBM die is resolved by improving in-plane spreading thermal resistance of the die cannot be implemented. An in-plane heat spreading capability of the die needs to be improved, to quickly spread heat of the local hot spot in the die in a plane direction, so as to reduce the in-plane thermal resistance of the die.

FIG. 3A is a cross-sectional view of a semiconductor apparatus 300 for which a CoWoS package is used according to some implementations disclosed in this application. A difference from the semiconductor apparatus 200 shown in FIG. 2 is that in the semiconductor apparatus 300, a thermally conductive layer 314 is disposed at a bottom-layer die 306. Other parts in FIG. 3A are basically the same as those in FIG. 2. Details are not described herein.

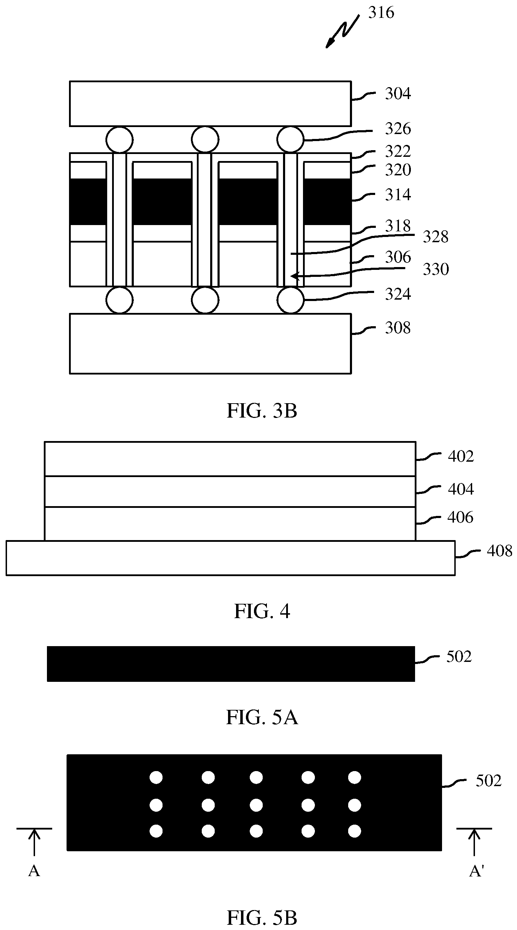

FIG. 3B is an enlarged view of a part 316 of the semiconductor apparatus 300. As shown in FIG. 3, the semiconductor apparatus 300 includes the bottom-layer die 306, a first insulation layer 318 disposed above the bottom-layer die 306, the thermally conductive layer 314 disposed above the first insulation layer 318, and a second insulation layer 320 disposed above the thermally conductive layer 314. In addition, an insulation layer 322 may be disposed on a sidewall of a via 330 and above the second insulation layer 320. A conductive pillar 328 is disposed in the via 330 to form a through silicon via (TSV) structure, and is insulated from the thermally conductive layer 314 by using the insulation layer 322. An interconnection layer 308 is interconnected with the conductive pillar 328 by using a solder ball 324, and a core die 304 is interconnected with the conductive pillar 328 by using a solder ball 326. In this way, I/O pins of the core die 304 are vertically interconnected with I/O pins of the bottom-layer die 306 by using the conductive pillar 328, and the bottom-layer die 306 is electrically interconnected with the interconnection layer 308 by using the solder ball 326. A logic die such as a controller 302 may be further assembled in another region of the interconnection layer 308. The bottom-layer die 306, the core die 304, the controller 302, and a package substrate 310 are electrically interconnected by using the interconnection layer 308. It should be understood that the part 316 of the semiconductor apparatus 300 may be implemented by using the semiconductor apparatus 100 shown in FIG. 1A and FIG. 1B.

Additionally or alternatively, in the semiconductor apparatus 300 shown in FIG. 3A, a thermally conductive layer (not shown) may be further disposed above the controller 302. In this way, package space in the semiconductor apparatus 300 can be fully used, and a heat spreading effect of the controller 302 can be improved. In an example embodiment, the controller 302 may be further thinned to more conveniently accommodate the thermally conductive layer.

FIG. 4 is a schematic diagram of a simulation structure according to an embodiment disclosed in this application. In this embodiment, there is a printed circuit board (PCB) 408, a substrate 406 disposed above the PCB 408, an HBM2 memory die module 404 disposed above the substrate 406, and an epoxy resin (EMC) 402 disposed above the HBM die stack 404. In this embodiment, a graphene-based thermally conductive layer is integrated above a bottom-layer die, for example, as shown in FIG. 3A and FIG. 3B.

In a conventional technology, when four layers of HBM2 dies are in a 2.0 Gbps working mode, a temperature of a highest temperature point in the bottom-layer die is 24°C higher than a lowest temperature. A simulation model is constructed for the scenario in which there are four layers of HBM2 dies, and a scenario in which the temperature of the highest temperature point in the bottom-layer die is 24°C higher than the lowest temperature is reconstructed. On this basis, a set of simulation conditions is added, and a thermally conductive material that has a thickness of 50 µm and an in-plane coefficient of thermal conductivity of 1500 W/mk is added to the bottom-layer die.

A size of the HBM die stack 404 is 11 mm×8 mm, power of the bottom-layer die is 4 W, and power of each DRAM HBM die is 0.75 W (4 W in total). In a simulation process, a temperature of the EMC 402 is fixed at a room temperature 25 degrees. A surface temperature of the bottom-layer die in the conventional technology is between 63°C and 87°C (ΔT=24°C). According to this embodiment disclosed in this application, a surface temperature of the bottom-layer die is between 65°C and 75°C (ΔT=12°C). A thermal simulation result shows that an in-plane temperature difference of the bottom-layer die may be reduced from 24°C to 12°C, in other words, an in-plane heat spreading capability of the silicon-based bottom-layer die is increased by one time. This is equivalent to that a temperature specification of a die in a memory die module in a 3D IC die package is increased by 12°C.

As described above, in addition to a graphene film, another thermally conductive material such as a graphene-based composite film, a graphite film, a graphite/metal composite film, a metal/carbon composite film, or even a copper alloy film may be used.

When these non-graphene film materials are used, it is difficult to obtain an in-plane coefficient of thermal conductivity that is greater than 1500 W/mk, but it is easy to obtain an in-plane coefficient of thermal conductivity that is greater than 400 W/mk. Based on the simulation model shown in FIG. 4, when a thermally conductive material that has a thickness of 50 µm and an in-plane coefficient of thermal conductivity of 400 W/mk is integrated to a surface of the bottom-layer die, a thermal simulation result shows that the in-plane temperature difference of the bottom-layer die may be reduced from 24°C to 18.8°C. Therefore, even if the graphene film is not used, an in-plane heat-conducting capability of the silicon-based die can be improved by at least 50%.

The example embodiments disclosed in this application are described below with reference to a specific environment, for example, a die-on-wafer-on-substrate (CoWoS) package. More specifically, the CoWoS package includes a multi-layer memory die stack. The stack includes a bottom-layer die and one or more layers of core dies disposed above the bottom-layer die. However, the example embodiments disclosed in this application are also applicable to another package type and another die structure, including another three-dimensional integrated circuit (3D IC) package, another 2.5D IC package, and the like.

FIG. 5A to FIG. 5Q are schematic diagrams of stages of manufacturing a semiconductor apparatus according to a first embodiment disclosed in this application. FIG. 5A is a cross-sectional view of a graphene film 502. For example, for the graphene film 502, a thickness may be approximately 55 µm, and an in-plane coefficient of thermal conductivity may be between 1500 W/mk to 1700 W/mk. It should be understood that the thickness and the in-plane coefficient of thermal conductivity of the graphene film may vary with a specific application requirement and a manufacturing process. For example, the graphene film 502 may be commercially purchased. In addition, a single layer of graphene oxide dispersion with a large size (with a plane size of at least 20 µm) may be used to prepare slurry and then coating is performed to form a film, and a graphene film 502 with a desired thickness may be manufactured by performing a heat treatment process and a compaction process for a plurality of times. It should be understood by a person skilled in the art that the graphene film 502 may be manufactured by using any other suitable process.

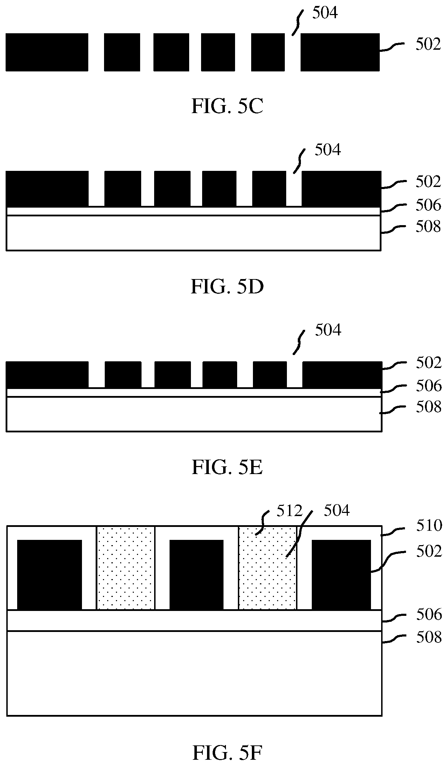

A via 504 may be formed in the graphene film 502 based on a predefined position. FIG. 5B is a plan view of the graphene film 502, and FIG. 5C is a cross-sectional view at a position corresponding to a cross section A-A' in FIG. 5B. A plurality of vias 504 are shown in FIG. 5B and FIG. 5C. It should be understood that a quantity, a shape, a size, and a distribution position of vias 504 shown in FIG. 5B and FIG. 5C are provided as examples, and the quantity, the shape, the size, and the distribution position of vias 504 may be determined based on a specific application. For example, in a die stack such as a high bandwidth memory (HBM) die stack, the size and the distribution position of the via 504 may be determined based on a requirement for vertically interconnecting a bottom-layer die and a core die in the HBM die stack.

To lower a requirement for high-precision alignment in a backend process, a diameter size of the via 504 may be greater than an aperture of a through silicon via (TSV) of the bottom-layer die and the core die in the HBM stack. For example, in an example of a four-layer high-bandwidth memory (HBM2) die stack, there are 5024 I/Os, a corresponding area is approximately 1 mm×6 mm, via density may be approximately 170 per square millimeter, a typical via diameter is approximately between 10 µm and 40 µm, and a maximum via diameter is approximately 76 µm. It should be understood that these values are provided only as examples, and are not intended to limit the scope of the present invention.

The via 504 may be manufactured by using various punching processes, including laser punching, drill drilling, and the like. Before the via 504 is manufactured, a mask may be manufactured based on a preset position requirement, to determine a punching position, so as to facilitate manufacturing of the via 504. It should be understood that the via 504 may be manufactured by using any other suitable technology.

Then, the graphene film 502 may be bonded to a first carrier wafer 508, to facilitate subsequent processing. For example, as shown in FIG. 5D, the graphene film 502 may be bonded to the first carrier wafer 508 by using a bonding material 506. For example, the bonding material 506 is a peelable bonding material such as a heat-sensitive adhesive material or a UV-sensitive adhesive material, to facilitate subsequent peeling-off of the first carrier wafer 508. Bonding strength of the heat-sensitive adhesive material is decreased greatly when a temperature is changed, and bonding strength of the UV-sensitive adhesive material is decreased greatly under UV illumination. It should be understood that the graphene film 502 may be bonded to the first carrier wafer 508 by using any other suitable method.

The first carrier wafer 508 may be made of a material such as glass or silicon. A size of the first carrier wafer 508 may be consistent with a size of the graphene film 502, for example, 4 inches, 6 inches, 8 inches, or 12 inches. In some cases, the size and a shape of the graphene film 502 may be inconsistent with those of the first carrier wafer 508. Therefore, the graphene film 502 may be cut into a round size, and then the graphene film 502 may be attached to a surface of the first carrier wafer 508 by using the bonding material 506.

As shown in FIG. 5E, the graphene film 502 is thinned. For example, a back of the graphene film 502 may be ground through chemical mechanical grinding, to thin the graphene film 502 from 55 µm to 50 µm. In this way, surface roughness of the graphene film 502 may reach a nanometer level, for example, less than or equal to 1 nm. For example, the surface roughness is less than 0.5 nm. Alternatively, a graphene film 502 that has an appropriate thickness and surface roughness that meets a desired requirement may be used, to omit a thinning step.

As shown in FIG. 5F, an insulating material 510 is formed on an exposed surface of the graphene film 502. For example, the insulating material is deposited on an upper surface of the graphene film 502 and a sidewall of the via 504. For example, the insulating material 510 may be a low-dielectric material that has a property such as temperature resistance that can meet a subsequent semiconductor manufacturing process, for example, silicon oxide. Other optional materials include at least one of silicon nitride, silicon carbide, silicon oxide, silicon oxycarbide, fluorinated silicon glass, carbon-doped silicon oxide, and polymer. For example, a thickness of the insulating material 510 may be approximately 100 nm. It should be understood that this value is provided only as an example, and is not intended to limit the scope of the present invention.

Based on a specific process method and a requirement, the insulating material 510 may include a plurality of material layers, for example, a passivation layer, a barrier layer, and a dielectric layer. For example, the insulating material 510 may be deposited by using various methods, for example, physical deposition or chemical deposition.

The via 504 in the graphene film 502 has a relatively large size, and therefore may be difficult to be evenly filled by using a film deposition process. In this case, after insulation isolation is implemented on the sidewall of the via 504 by using the insulating material 510, a filler material 512, for example, an insulating material (for example, silicon oxide) and/or a semiconductor material (for example, silicon), compatible with a semiconductor TSV process may be formed in the via 504.

After the filler material 512 is formed in the via 504, surface leveling may be implemented by using various suitable polishing processes. For example, surface roughness that is less than or equal to 1 nm (for example, less than 0.5 nanometers) may be implemented, to facilitate subsequent bonding to the bottom-layer die.

In some embodiments, the first carrier wafer 508 may be removed by virtue of a peelable property of the bonding material 506, to form a heat spreader. The heat spreader includes a carbon-based material layer (for example, the graphene film 502), and a coefficient of thermal conductivity of the carbon-based material layer in a horizontal direction is greater than or equal to a coefficient of thermal conductivity in a vertical direction. In addition, the heat spreader further includes a first non-metal pillar. The first non-metal pillar penetrates through the carbon-based material layer (for example, the graphene film 502), and the first non-metal pillar is made of an insulating material or a semiconductor material, for example, silicon or silicon oxide. In an example shown in FIG. 5F, the first non-metal pillar may include the insulating material 510 and the filler material 512 on two sides of the insulating material 510 shown in FIG. 5F. A part that is of the first non-metal pillar and that is in contact with the graphene film 502 is the insulating material 510. For example, a diameter of the first non-metal pillar may be between 10 µm and 40 µm.

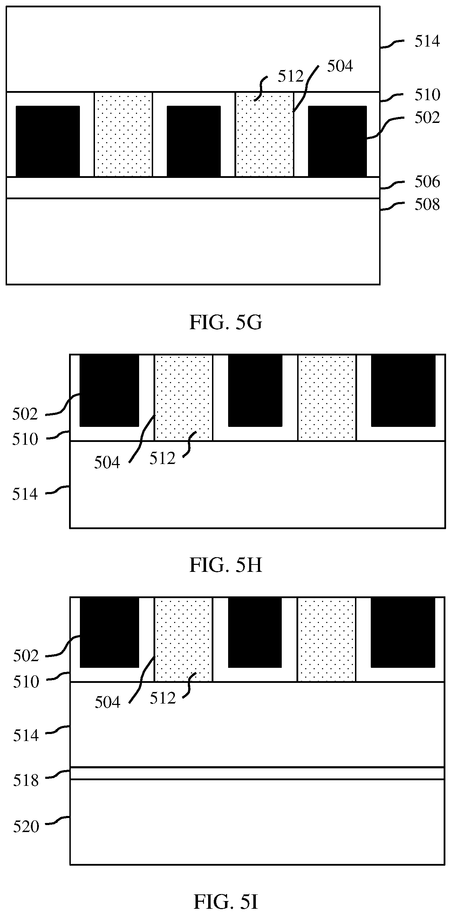

In FIG. 5G, the graphene film 502 is bonded to a first semiconductor layer 514. In a wafer level packaging process, the first semiconductor layer 514 may be a wafer including a plurality of first dies or a plurality of first interconnection layers, and may be cut into a plurality of first dies or a plurality of first interconnection layers. For example, the first semiconductor layer 514 may include an active structure such as a circuit, to implement a corresponding die function, and may be cut into a plurality of first dies. For example, the graphene film 502 and the first semiconductor layer 514 may be bonded by using a wafer bonding process. Various suitable wafer bonding processes, especially a surface activated bonding (SAB) processes, may be used. In the SAB bonding process, silicon oxide that has a thickness at an nm level is deposited on a surface of the first semiconductor layer 514, silicon oxide that has a thickness at an nm level is deposited on a surface of the insulating material 510, and bonding is directly performed under a specific temperature and pressure condition.

During bonding of the graphene film 502 and the first semiconductor layer 514, the via 504 in the graphene film 502 and a position at which a TSV via needs to be manufactured and that is at the first semiconductor layer 514 may be preliminarily aligned as required.

In FIG. 5H, the first carrier wafer 508 is separated from the graphene film 502. The first carrier wafer 508 may be peeled off from the graphene film 502 based on the peelable property of the bonding material 506. For example, in an embodiment in which the bonding material 506 is a heat-sensitive adhesive material, bonding strength of the heat-sensitive adhesive material between the first carrier wafer 508 and the graphene film 502 may be significantly reduced through heating, and then force is applied to separate the first carrier wafer 508 from the graphene film 502. In an embodiment in which the bonding material 506 is a UV-sensitive adhesive material, bonding strength of the UV-sensitive adhesive material between the first carrier wafer 508 and the graphene film 502 may be significantly reduced through UV illumination or the like, and then force is applied to separate the first carrier wafer 508 from the graphene film 502.

In FIG. 51, the first semiconductor layer 514 is bonded to a second carrier wafer 520. The first semiconductor layer 514 may be bonded to the second carrier wafer 520 by using a bonding material 518, which is similar to that in FIG. 5D. For example, the bonding material 518 is a peelable bonding material such as a heat-sensitive adhesive material or a UV-sensitive adhesive material, to facilitate subsequent peeling-off of the second carrier wafer 520.

In addition, an insulating material 516 is formed on an exposed surface of the graphene film 502. For example, the insulating material 516 may be formed by using a deposition method, for example, physical deposition or chemical deposition. Before the insulating material 516 is formed, surface treatment such as grinding/cleaning may be performed on a surface of the graphene film 502, to improve surface flatness.

In some examples, the insulating material 516 may be a low-dielectric material that has a property such as temperature resistance that can meet a subsequent semiconductor manufacturing process, for example, silicon oxide. Other optional materials include at least one of silicon nitride, silicon carbide, silicon oxide, silicon oxycarbide, fluorinated silicon glass, carbon-doped silicon oxide, and polymer. For example, a thickness of the insulating material 516 may be approximately 100 nm. It should be understood that this value is provided only as an example, and is not intended to limit the scope of the present invention.

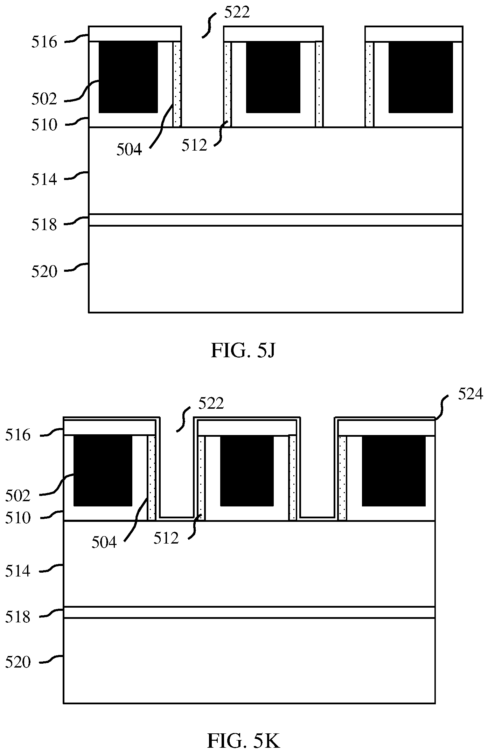

As shown in FIG. 5J, a via 522 is formed in the graphene film 502 based on a specified position. The via 522 may pass through the insulating material 516 and the filler material 512. For example, punching processing may be performed through reactive ion etching (RIE). In RIE, oxygen plasma may be used, or hydrogen plasma or argon plasma may be selected. To use RIE, masking processing needs to be performed on the surface of the graphene film 502 in advance, to define a position at which the via 522 is to be formed. A hole may be designed based on an actual requirement. For example, an aperture diameter of the via 522 may range from 2 µm to 20 µm.

In FIG. 5K, an insulating material 524 is formed on an exposed upper surface of a structure shown in FIG. 5J. Specifically, the insulating material 524 is formed on a surface of the insulating material 516 and a surface of the filler material 512 (namely, a sidewall of the via 522). The insulating material 524 may be a passivation layer, for example, silicon nitride. A thickness of the insulating material 524 may be approximately between 100 µm and 300 µm. For example, the insulating material 524 may be formed by using a deposition process, for example, a physical deposition or chemical deposition process.

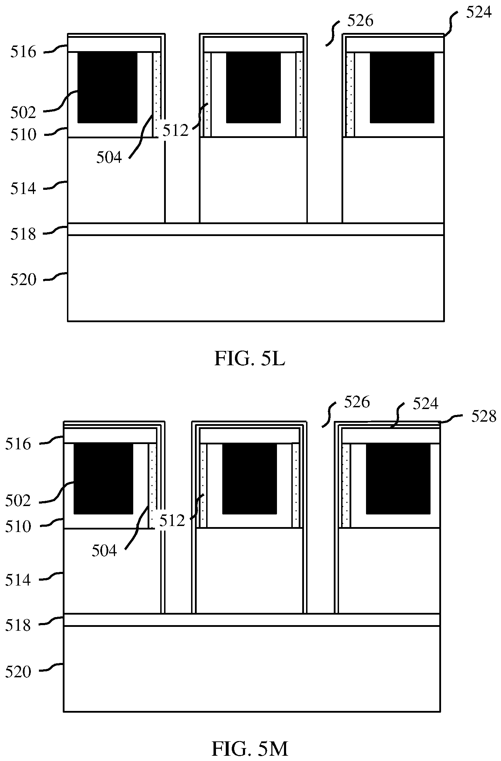

As shown in FIG. 5L, a via 526 is formed at the first semiconductor layer 514 based on a specified position. This is similar to a via last (via last) process. For example, the via 526 may be formed by using a Bosch process or a deep reactive ion etching process. In the Bosch process, the via 526 may be implemented by alternating plasma SF₆ and C₄F₈. A position of the via 526 corresponds to the position of the via 522, for example, central positions of the two vias are consistent, and sizes may be the same or very similar to each other. A hole is designed based on an actual requirement, and an aperture diameter usually ranges from 2 µm to 20 µm.

As shown in FIG. 5M, an insulation layer 528 is formed on an upper surface of a structure in FIG. 5L. Specifically, the insulation layer 528 is formed on a surface of the insulating material 524 and a sidewall of the via 526. The insulation layer 528 may be formed through deposition, for example, a physical deposition or chemical deposition process. The insulation layer 528 may include silicon oxide or silicon nitride, and a thickness of the insulation layer 528 may be approximately 100 nm.

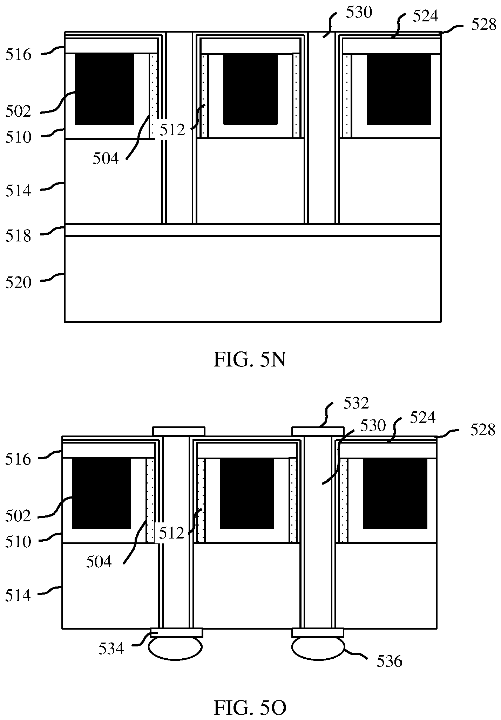

In FIG. 5N, the via 526 is filled with a conductive material, to form a conductive pillar 530. For example, the conductive pillar 530 may be formed through electrolytic plating. In electrolytic plating, a barrier layer and a seed layer are first sequentially deposited on an exposed surface of the via 526. A material of the barrier layer may include tantalum nitride, titanium nitride, tungsten titanide, titanium, tantalum, chromium, a combination thereof, or the like. A thickness of the barrier layer may be approximately 300 nm. A material of the seed layer may include copper or the like, and a thickness of the seed layer may be 200 nm. It should be understood that this value is provided only as an example, and is not intended to limit the scope disclosed in this application. Then, electroplated copper is formed in the via 126 by using an electrolytic plating process, to fill the via 526. Alternatively, the conductive pillar 530 may be formed by using another suitable method such as an electroless process.

After the vias 526 is filled, unnecessary copper and an unnecessary barrier layer material on an upper surface may be removed through chemical mechanical grinding or the like, to form a structure shown in FIG. 5N.

Then, as shown in FIG. 5O, a pad, for example, pads 532 and 534, may be formed at one or two ends of the via 526 as required. For example, the pads 532 and 534 may be manufactured through electroplating, for example, by performing gold plating or copper plating on the surface.

In an example, the pad 532 on a side close to the graphene film 502 may be first manufactured, and after manufacturing is completed, the first semiconductor layer 514 is separated from the second carrier wafer 520. For example, the second carrier wafer 520 may be peeled off from the first semiconductor layer 514 based on a peelable property of the bonding material 518. Then, the pad 534 is manufactured at a bottom of the first semiconductor layer 514, and then an array of solder balls 536, for example, a micro boss copper pillar, is manufactured. In another example, the first semiconductor layer 514 may be first separated from the second carrier wafer 520, and then the pads 532 and 534 may be respectively formed at two ends of the via 526.

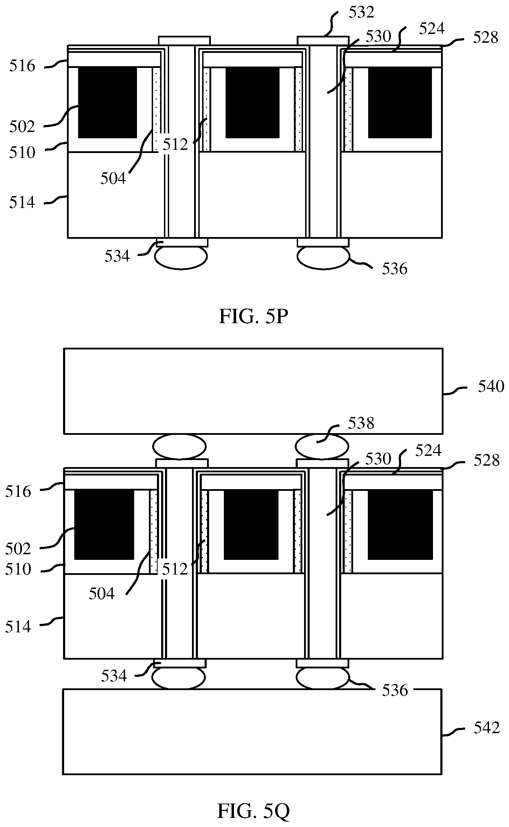

As shown in FIG. 5P, a second die 540 and the first semiconductor layer 514 may be bonded by using a wafer-to-wafer (wafer to wafer) process. For example, the second die 540 may be a fourth core die wafer in a four-layer HBM2 die stack, and the first semiconductor layer 514 may be a bottom-layer die wafer in the four-layer HBM2 die stack. Based on an actual requirement, after a plurality of layers of HBM dies are stacked, die cutting may be performed to manufacture a memory die module in which four layers of HBM2 dies are stacked.

As shown in FIG. 5Q, the memory die module may be soldered to a third semiconductor layer 542 by using a die-to-wafer (die to wafer) or die-to-die (die to die) process. The third semiconductor layer 542 may be a third interconnection layer or a third die. When the third semiconductor layer 542 is a third interconnection layer, the memory die module may be interconnected with another logic die or a package substrate by using the third semiconductor layer 542.

According to the first embodiment, a graphene film is integrated on one side of the bottom-layer die, and a TSV that penetrates through the graphene film is used as a vertical interconnection between the bottom-layer die and the core die. For the graphene film, a relatively large via is manufactured and a surface isolation measure is taken in advance, so that three-dimensional dies can be vertically interconnected after a highly thermally conductive and electrically conductive graphene film is integrated. In addition, the relatively large via manufactured in the graphene film in advance is filled with a material compatible with the TSV process, to significantly reduce difficulty of the TSV process in backend three-dimensional die integration.

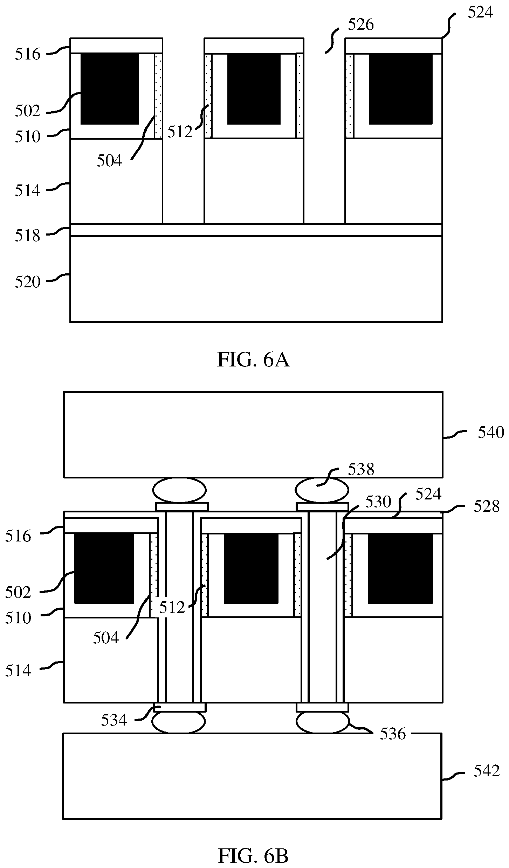

A manufacturing method according to the first embodiment disclosed in this application is described above with reference to FIG. 5A to FIG. 5Q. It should be understood that a person skilled in the art may make various possible modifications to the procedure without departing from the scope disclosed in this application. Several variants of the manufacturing method according to the first embodiment are described below with reference to FIG. 6A to FIG. 7D.

FIG. 6A and FIG. 6B are schematic diagrams of a first variant of the manufacturing method according to the first embodiment. The first variant of the first embodiment begins with a structure shown in FIG. 5I. Then, in the first variant of the first embodiment, a via 526 that passes through an insulating material 516, a filler material 512, and a first semiconductor layer 514 is formed, as shown in FIG. 6A, which is different from that in FIG. 5J. Then, a structure shown in FIG. 6B is formed based on steps the same as those in FIG. 5M to FIG. 5Q. A main difference between the first variant of the first embodiment and the first embodiment is that punching shown in FIG. 5J and punching shown in FIG. 5L are modified to be simultaneously performed.

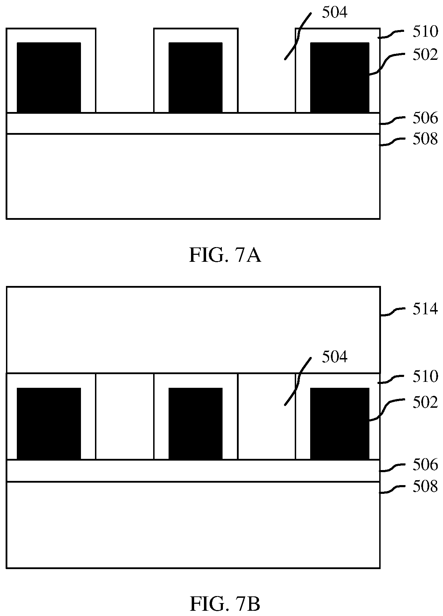

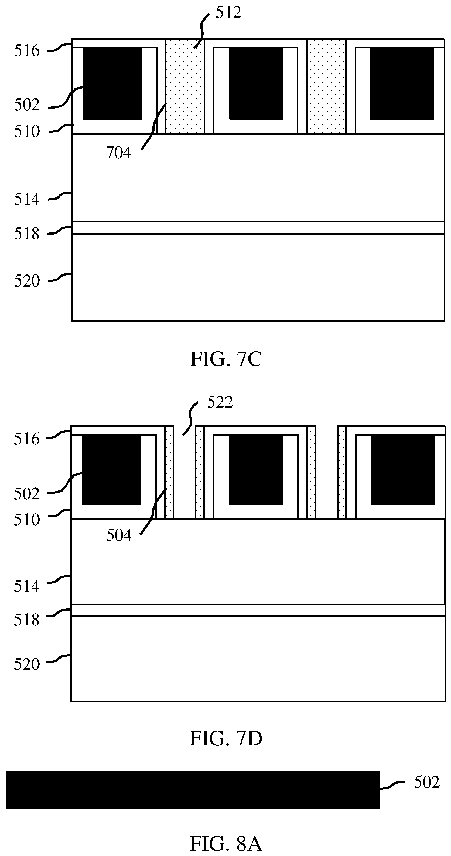

FIG. 7A to FIG. 7D are schematic diagrams of a second variant of the manufacturing method according to the first embodiment. The second variant of the first embodiment begins with a structure shown in FIG. 5E. Then, in the second variant of the first embodiment, only an insulating material 510 is formed, and a via 504 is not filled with a filler material 512, as shown in FIG. 7A, which is different from that in FIG. 5F. In FIG. 7B, a first semiconductor layer 514 is bonded to a graphene film 502, which is similar to that in FIG. 5G. Then, process procedures the same as those in FIG. 5H and FIG. 5I are performed. As shown in FIG. 7C, an insulating material 516 is formed on an exposed surface of the graphene film 502, and the via 504 is filled with the filler material 512. Then, in FIG. 7D, a via 522 is formed in the filler material 512. Subsequent steps are the same as those shown in FIG. 5K to FIG. 5Q. Details are not described. A main difference between the second variant of the first embodiment and the first embodiment is that the process of the filling material in FIG. 5F is modified to be performed before punching in FIG. 5J is performed.

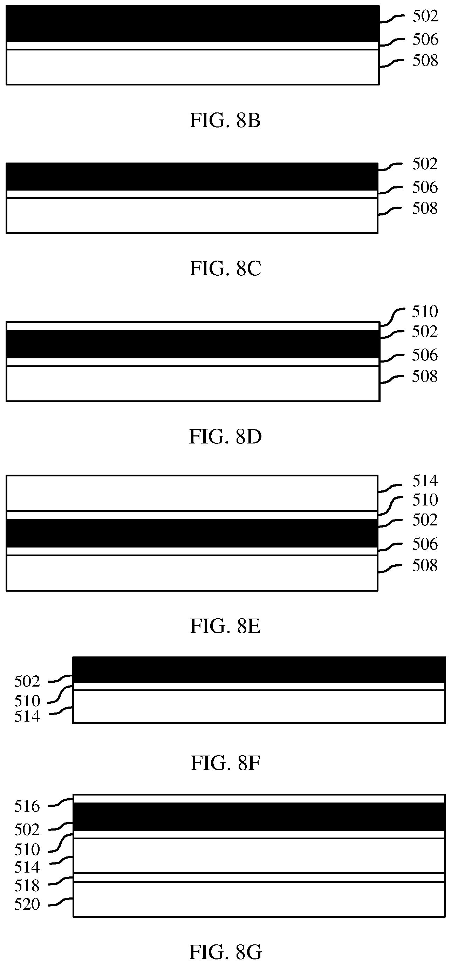

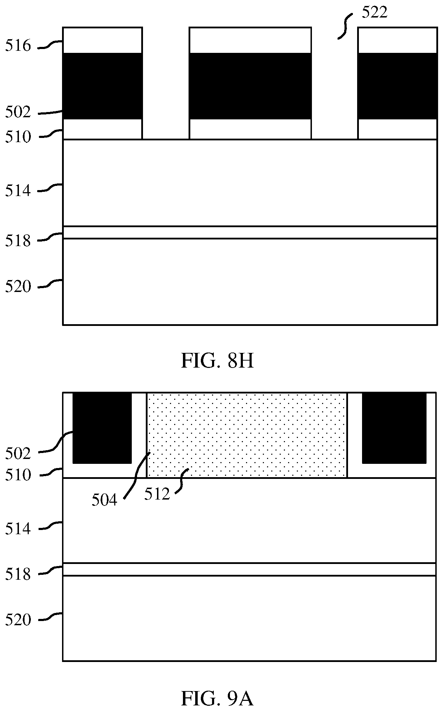

FIG. 8A to FIG. 8H are schematic diagrams of several stages of manufacturing a semiconductor apparatus according to a second embodiment disclosed in this application. FIG. 8A is similar to FIG. 5A, and a graphene film 502 is provided. In FIG. 8, the graphene film 502 is bonded to a first carrier wafer 508 by using a bonding material 506, which is similar to that in FIG. 5D. In FIG. 8C, the graphene film 502 is thinned, which is similar to that in FIG. 5E. In FIG. 8D, an insulating material 510 is deposited on the graphene film 502, which is similar to that in FIG. 5F. In FIG. 8E, a first semiconductor layer 514 is bonded to the insulating material 510, which is similar to that in FIG. 5G. In FIG. 8F, the first carrier wafer 508 is peeled off, which is similar to that in FIG. 5H. In FIG. 8G, the first semiconductor layer 514 is bonded to a second carrier wafer 520, and an insulating material 516 is formed on the graphene film 502, which are similar to those in FIG. 5I and FIG. 5J. In FIG. 8H, a via 522 that penetrates through the insulating material 510, the thermally conductive layer 502, and the insulating material 516 is formed, which is similar to that in FIG. 5J. Subsequent steps are the same as those in FIG. 5K to FIG. 5Q.

A difference between the second embodiment and the first embodiment lies in a procedure of manufacturing a via in the graphene film 502. In the first embodiment, a plurality of vias 504 are manufactured in the graphene film 502 in the process procedures in FIG. 5B and FIG. 5C, the via 504 in the graphene film 504 is filled in the process procedure in FIG. 5F, and punching processing is performed on the filling material 512 in the graphene film 502 in the process procedure shown in FIG. 5J. In contrast, in the second embodiment, no via needs to be manufactured in advance in the graphene film 502. Specifically, the punching processes shown in FIG. 5B and FIG. 5C in the first embodiment are removed, and therefore no via needs to be filled in FIG. 5F, and a via is manufactured only at a corresponding position of the graphene film 102 in FIG. 5J. In comparison with the first embodiment, in the second embodiment, a challenge that is of position alignment between the via in the graphene film and a via in a bottom-layer die and that may occur in the first embodiment is avoided.

FIG. 9A to FIG. 9C are schematic diagrams of several stages of manufacturing a semiconductor apparatus according to a third embodiment disclosed in this application. FIG. 5A to FIG. 5H in the first embodiment may be applied to the third embodiment. However, a larger via may be implemented in the punching processes shown in FIG. 5B and FIG. 5C. For example, a size of a via 504 may be at a millimeter level. For an HBM2 scenario, a maximum size of the via 504 may be designed as an entire effective I/O pin area, for example, 1 mm×6 mm. Alternatively, the via 504 may be manufactured with a size that is greater than 110 µm×110 µm. In this case, the via 504 may be in various suitable shapes, for example, a round shape and a square shape. The via 504 has a larger size, and therefore the via 504 may be manufactured by using a simpler die cutting process suitable for performing mass manufacturing at low costs or another suitable process.

In FIG. 5F, an insulating material 510 is formed on an exposed surface of the graphene film 502. Then, the via 504 is filled with a material compatible with a TSV process, for example, silicon. The via 504 has a larger size, and therefore the via 504 may be filled by using various processes. For example, filling with slurry made of silicon powder may be performed by using a coating process, and a dense filler material may be formed after sintering and curing are performed under a specific process condition.

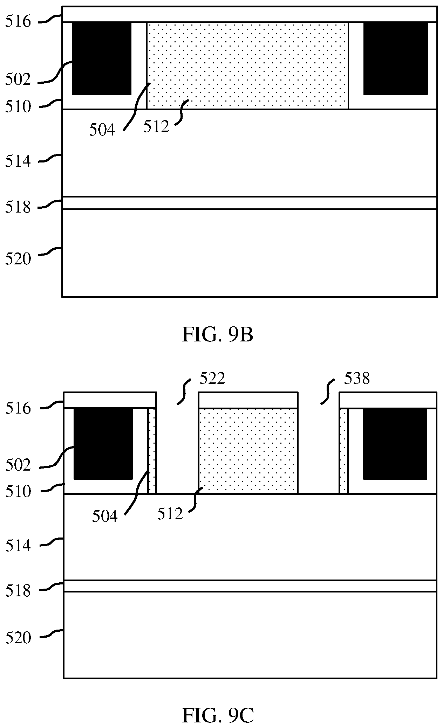

After a process procedure shown in FIG. 5H is performed, a structure shown in FIG. 9A may be formed, and the via 504 is filled with a filler material 512, which is similar to that in FIG. 5I. Then, in FIG. 9B, an insulating material 516 is formed on the graphene film 502, which is similar to that in FIG. 5J. In FIG. 9C, a via 522 is formed in the graphene film 502, which is similar to that in FIG. 5K. A difference from FIG. 5K is that in FIG. 9C, two vias 522 and 538 are formed in the via 504. It should be understood that more than two vias may be formed in the via 504. Other process procedures are basically the same as those in the first embodiment. Details are not described herein.

The third embodiment is similar to the first embodiment, and an in-plane temperature difference of a bottom-layer die can also be significantly reduced, to improve an in-plane heat-conducting capability of the bottom-layer die. In comparison with the first embodiment, an actual area of the graphene film 502 in the third embodiment is reduced, and performance of improving the in-plane temperature difference of the bottom-layer die may be slightly reduced. This specifically depends on the size of the via 504. However, the size of the via 504 is significantly increased, and therefore technical difficulty of manufacturing a via in the graphene film 502 can be significantly reduced in the third embodiment. In addition, in the third embodiment, the via 504 may be filled by using a process such as coating. In this way, costs can be significantly reduced in comparison with a deposition process.

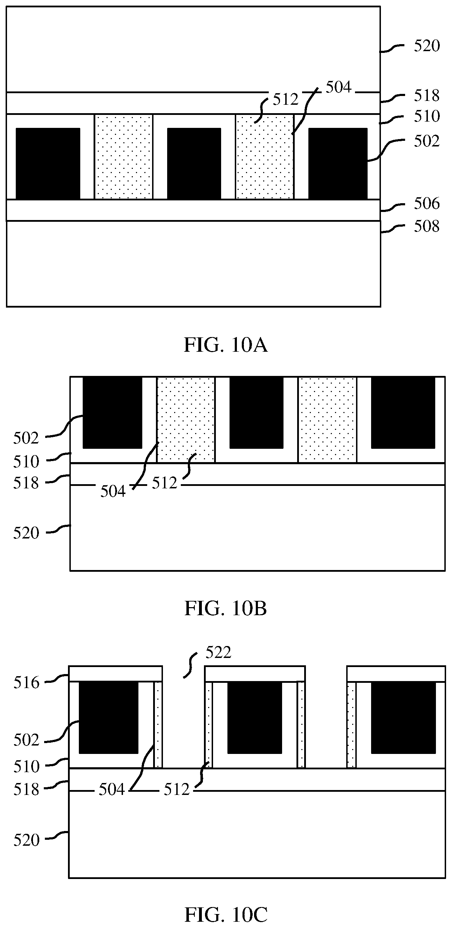

FIG. 10A to FIG. 10I are schematic diagrams of several stages of manufacturing a semiconductor apparatus according to a fourth embodiment disclosed in this application. In the fourth embodiment, the process procedures shown in FIG. 5A to FIG. 5F are first performed. Then, a second carrier wafer 520 is bonded to an upper surface of the graphene film 502, especially the insulating material 510. Specifically, the second carrier wafer 520 may be bonded to the graphene film 502 by using a bonding material 518. For example, the bonding material 508 may be different from the bonding material 506, so that the bonding material 508 is not removed when the bonding material 506 is removed. For example, the bonding material 506 may be a heat-sensitive adhesive material, and the bonding material 518 may be a UV-sensitive adhesive material. Alternatively, the bonding material 506 may be a UV-sensitive adhesive material, and the bonding material 518 may be a heat-sensitive adhesive material. Alternatively, the second carrier wafer 520 may be bonded to the graphene film 502 by using another suitable bonding process.

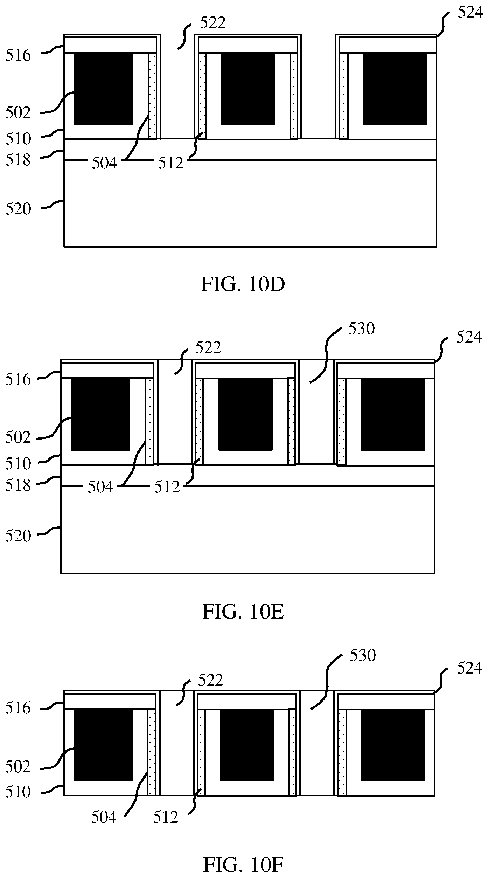

In FIG. 10B, the first carrier wafer 508 is removed and the graphene film 502 is inverted, which is similar to that in FIG. 5H. In FIG. 10C, an insulating material 516 is formed on the graphene film 502, and a via 522 is formed in a filler material 512 and the insulating material 516, which is similar to that in FIG. 5J. In FIG. 10D, an insulating material 524 is formed on a sidewall of the via 522 and a surface of the insulating material 516, which is similar to that in FIG. 5K. In FIG. 10E, the via 522 is filled with a conductive material, to form a conductive pillars 530, which is similar to that in FIG. 5N. In FIG. 5F, the second carrier wafer 520 is peeled off to form a heat spreading layer structure including a vertical interconnection, which is similar to that in FIG. 5O.

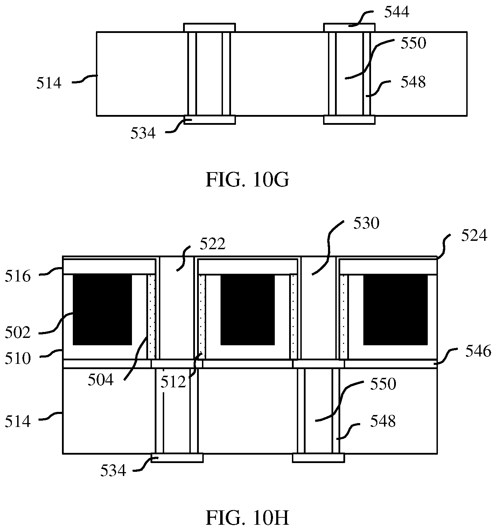

In FIG. 10G, a conductive pillar 550 and an insulating material 548 surrounding the conductive pillar 550 are formed at a first semiconductor layer 514 by using a TSV process. In addition, pads 534 and 544 are respectively formed at two ends of the conductive pillar 550.

In FIG. 10H, a structure shown in FIG. 10F is bonded to a structure shown in FIG. 10G. In a bonding process, the conductive pillar 530 may be aligned with the corresponding pad 544 at the first semiconductor layer 514, to form a vertical interconnection. Bonding may be implemented through wafer bonding or soldering. Before bonding, an insulating material 546 may be formed to implement a passivation function, and can perform an additional support function after bonding.

As shown in FIG. 10H, the conductive pillar 530 and the conductive pillar 550 may not have a same horizontal size, and the pad 534 is embedded in the middle as a part of the entire vertical interconnection. When a horizontal size of the conductive pillar 530 is greater than a horizontal size of the conductive pillar 550, a process of manufacturing the conductive pillar 530 is relatively simple and easy to implement, and there are low costs. However, it should be understood that the horizontal size of the conductive pillar 530 may alternatively be equal to or less than the horizontal size of the conductive pillar 550.

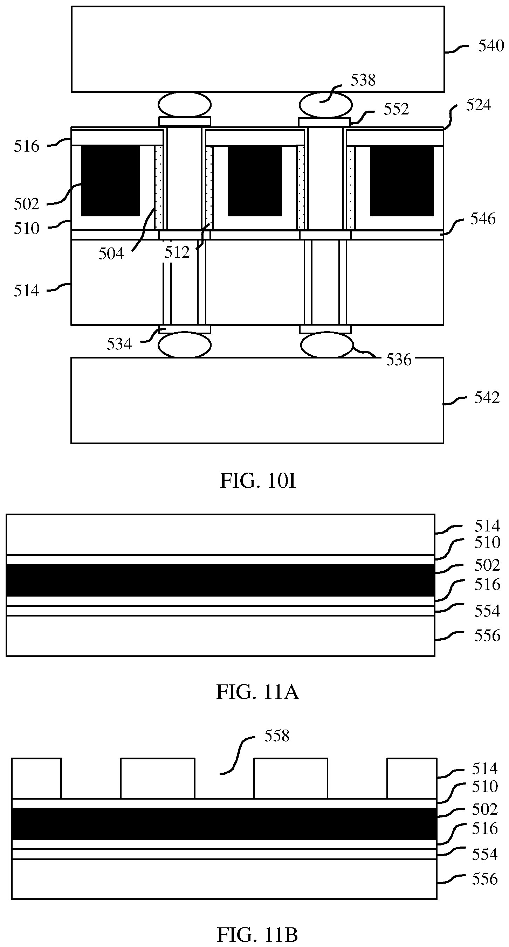

In FIG. 10I, a pad 552 is formed on the conductive pillar 530, and a second die 540 is bonded to the pad 552 by using a solder ball 538. In addition, the bottom-layer die 514 is bonded to a third semiconductor layer 542 by using a solder ball 536.

According to the fourth embodiment, a problem that there is in increase in process difficulty, complexity, and costs because of an excessively high TSV aperture ratio that is caused due to the fact that a TSV is manufactured in both a graphene film and a die wafer can be avoided.

FIG. 11A to FIG. 11J are schematic diagrams of stages of manufacturing a semiconductor apparatus according to a fifth embodiment disclosed in this application. In the fifth embodiment, the process procedures shown in FIG. 8A to FIG. 8G are first performed. Then, in FIG. 11A, the first semiconductor layer 514 is separated from the second carrier wafer 520 by virtue of a peelable property of a bonding material 518. Then, the graphene film 502, especially the insulating material 516, is bonded to a third carrier wafer 556, for example, by using a bonding material 554. The bonding material 554 may be similar to the bonding materials 506 and 518, and is a peelable bonding material.

In FIG. 11B, a via 558 is formed at the first semiconductor layer 514. For example, the via 558 may be formed through etching or a laser punching process. In this punching solution, compatibility with a TSV process is implemented, and high precision of positioning a via can be ensured. A size of the via 558 may be determined based on a specific requirement of the first semiconductor layer 514, for example, a diameter may be approximately 10 µm. It should be understood that this value is provided only as an example, and is not intended to limit the scope disclosed in this application.

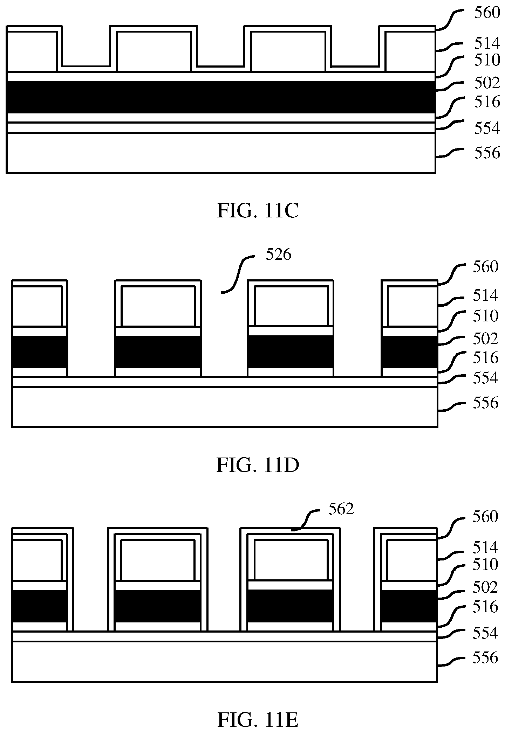

In FIG. 11C, an insulating material 560 is formed on an exposed surface of the first semiconductor layer 514. For example, the insulating material 560 may be formed by using a physical or chemical deposition process. The insulating material 560 may be used as a dielectric layer or a passivation layer. For example, the insulating material 560 may be a low-dielectric material that has a property such as temperature resistance that can meet a subsequent semiconductor manufacturing process, for example, silicon oxide. Other optional materials include at least one of silicon nitride, silicon carbide, silicon oxide, silicon oxycarbide, fluorinated silicon glass, carbon-doped silicon oxide, and polymer. Alternatively, the passivation step shown in FIG. 11C may not be performed.

In FIG. 11D, a via 526 is formed in the graphene film 502 and the insulating materials 510 and 516. For example, the via 526 may be formed through etching or a laser punching process. Alternatively, another suitable punching process may be used. For example, there may be relatively high punching efficiency if punching is performed by using a non-etching solution, especially laser punching.

In FIG. 11E, an insulating material 562 is formed in the via 526. Specifically, the insulating material 562 is formed on a sidewall of the via 526 and a surface of the insulating material 560. For example, the insulating material 562 may be formed by using a physical or chemical deposition process. The insulating material 562 may be used as a dielectric layer or a passivation layer. For example, the insulating material 562 may be a low-dielectric material that has a property such as temperature resistance that can meet a subsequent semiconductor manufacturing process, for example, silicon oxide. Other optional materials include at least one of silicon nitride, silicon carbide, silicon oxide, silicon oxycarbide, fluorinated silicon glass, carbon-doped silicon oxide, and polymer. For example, a thickness of the insulating material 562 may be approximately 100 nm. It should be understood that this value is provided only as an example, and is not intended to limit the scope disclosed in this application.

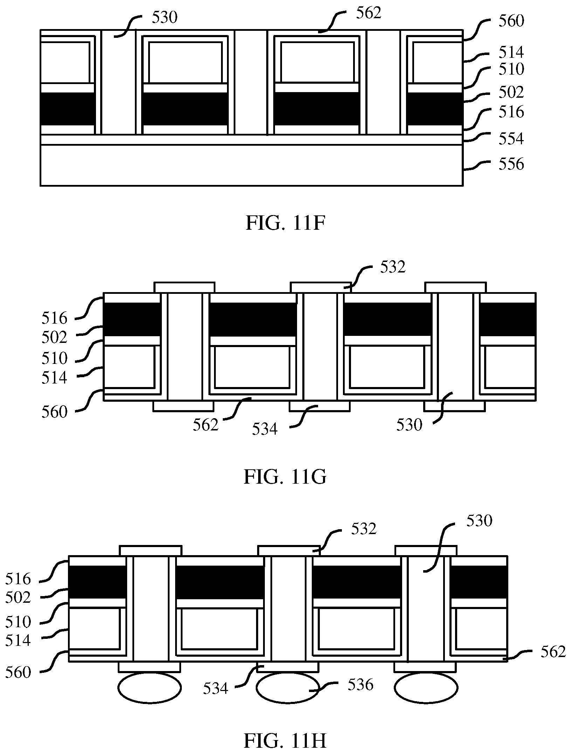

In FIG. 11F, a conductive material is formed to fill the via 526, so as to form a conductive pillar 530. For example, the conductive material may be formed through electrolytic plating. In electrolytic plating, a barrier layer and a seed layer are first sequentially deposited on an exposed surface of the via 526. A thickness of the barrier layer may be approximately 300 nm. A material of the seed layer may include copper or the like, and a thickness of the seed layer may be 200 nm. It should be understood that this value is provided only as an example, and is not intended to limit the scope disclosed in this application. Then, electroplated copper is formed in the via 126 by using an electrolytic plating process, to fill the via 526. Alternatively, the conductive material may be formed by using another suitable method such as an electroless process.

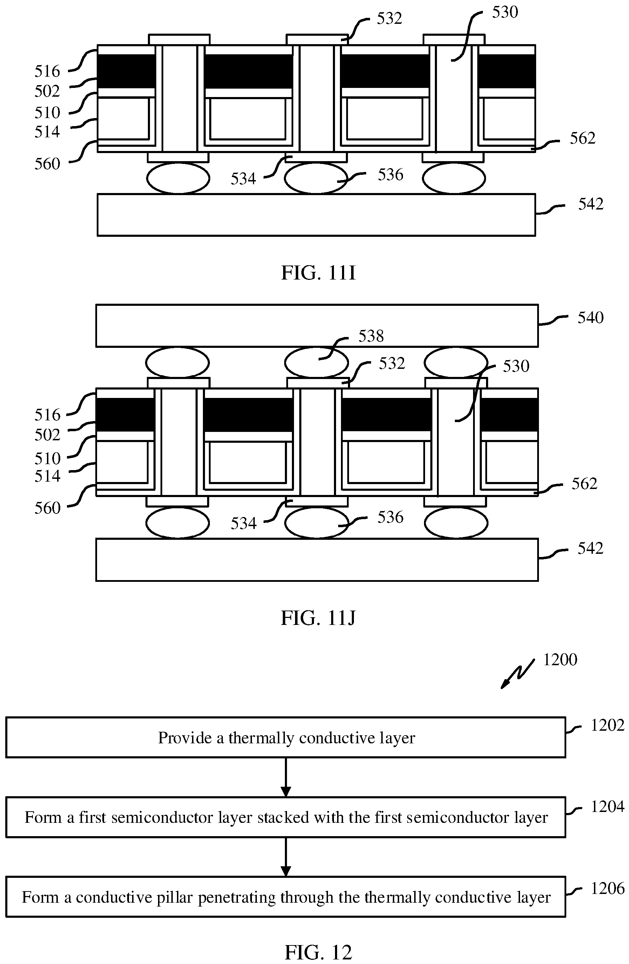

In FIG. 11G, the third carrier wafer 556 is removed by virtue of a peelable property of the bonding material 554. Then, the seed layer that may remain at a bottom of the via 526 is removed, and pads 532 and 534 are respectively formed at two ends of the conductive pillar 530 by using a metallization process. In FIG. 11H, a solder ball 536 is formed on the pad 534. In FIG. 11I, the first semiconductor layer 514 is bonded to a third semiconductor layer 542 by using the solder ball 536. For example, the third semiconductor layer 542 may be a third die or a third interconnection layer.

In FIG. 11J, a solder ball 538 is formed on the pad 532, and the first semiconductor layer 514 is bonded to a second die 540 by using the solder ball 538. For example, the second die 540 may be a fourth core die wafer in a four-layer HBM2 die stack, and the first semiconductor layer 514 may be a bottom-layer die wafer in the four-layer HBM2 die stack.

In comparison with the first embodiment, in the fifth embodiment, punching is performed on a die side, which is compatible with the TSV process and ensures high precision of positioning a via. Then, punching is performed on a grapheme side, and punching may be implemented by using a non-etching solution (for example, laser punching), to implement higher punching efficiency.

In the embodiments described above with reference to FIG. 5A to FIG. 11J, description is provided by using the graphene film as an example. However, the material of the thermally conductive layer 502 is not limited to the graphene-based film, and may alternatively be a graphene-based composite film such as a graphite/metal composite film, or may be a graphite film, a graphite/metal composite film, a metal/carbon composite film, even a copper alloy film, or the like. In addition, although the embodiments are separately described above, it should be understood that the embodiments may be combined in various suitable manners to form additional embodiments without departing from the scope disclosed in this application.

FIG. 12 is a flowchart of a method 1200 for manufacturing a semiconductor apparatus according to some implementations disclosed in this application. In a block 1202, a thermally conductive layer is provided. For example, the thermally conductive layer may be the thermally conductive layer 102, the thermally conductive layer 314, or the graphene film 502 described above.

In a block 1204, a first semiconductor layer stacked with the thermally conductive layer is formed. For example, the first semiconductor layer may be the first semiconductor layer 114 or the first semiconductor layer 514.

In a block 1206, a conductive pillar that penetrates through the first semiconductor layer is formed. The conductive pillar is electrically insulated from the thermally conductive layer. The conductive pillar may be the conductive pillar 130, 134, 530, or 550.

In some embodiments, the method 1200 may further include: forming a first insulation layer on a first surface of the thermally conductive layer. For example, as shown in FIG. 5F, the insulating material 510 is formed on the surface of the graphene film 502. In this embodiment, as shown in FIG. 5G, the first semiconductor layer (for example, the first semiconductor layer 514) is bonded to the first insulation layer (for example, the insulating material 510), to form the first semiconductor layer below the thermally conductive layer (for example, the graphene film 502).

In some embodiments, the method 1200 may further include: forming a second insulation layer (for example, the insulating material 516) on a second surface of the thermally conductive layer (for example, the graphene film 502). The second surface is opposite to the first surface, as shown in FIG. 5J. In this embodiment, a first via (for example, the via 526) that penetrates through the second insulation layer (for example, the insulating material 516), the thermally conductive layer (for example, the graphene film 502), the first insulation layer (for example, the insulating material 510), and the first semiconductor layer (for example, the first semiconductor layer 514) is formed, as shown in FIG. 5L. Then, the conductive pillar (for example, the conductive pillar 530) is formed in the first via (for example, the via 526), as shown in FIG. 5N.

In some embodiments, the forming a first insulation layer (for example, the insulating material 510) includes: forming a second via (for example, the via 504) at the thermally conductive layer (for example, the graphene film 502), as shown in FIG. 5B and FIG. 5C; and forming the first insulation layer (for example, the insulating material 510) on the first surface of the thermally conductive layer (for example, the graphene film 502) and a sidewall of the second via (for example, the via 504), as shown in FIG. 5F.

In some embodiments, the bonding the first semiconductor layer (for example, the first semiconductor layer 514) to the first insulation layer (for example, the insulating material 510) includes: filling the second via (for example, the via 504) with a filler material (for example, the filler material 512), as shown in FIG. 5F; and bonding the first semiconductor layer (for example, the first semiconductor layer 514) to the first insulation layer (for example, the insulating material 510) and the filler material (for example, the filler material 512), as shown in FIG. 5G.

In some embodiments, the forming a second insulation layer (for example, the insulating material 516) includes: forming the second insulation layer (for example, the insulating material 516) in the second via (for example, the via 504) and on the first surface of the thermally conductive layer (for example, the graphene film 502); and filling the second via (for example, the via 504) with the filler material (for example, the filler material 512), as shown in FIG. 7C.

In some embodiments, the forming a first via (for example, the via 526) includes: forming a third via (for example, the via 522) that penetrates through the second insulation layer (for example, the insulating material 516) and the filler material (for example, the filler material 512), as shown in FIG. 5J; forming a third insulation layer (for example, the insulating material 524) on sidewalls and at bottoms of the second insulation layer (for example, the insulating material 516) and the third via (for example, the via 522), as shown in FIG. 5K; and forming, at the third via (for example, the via 524), a fourth via that penetrates through the third insulation layer (for example, the insulating material 524) and the first semiconductor layer (for example, the first semiconductor layer 514), where the third via (for example, the via 522) and the fourth via form the first via (for example, the via 526), as shown in FIG. 5L.

In some embodiments, the forming a first via (for example, the via 526) includes: forming the first via (for example, the via 526) that penetrates through the second insulation layer (for example, the insulating material 516), the filler material (for example, the filler material 512), and the first semiconductor layer (for example, the first semiconductor layer 514), as shown in FIG. 6A.

In some embodiments, the forming a first via (for example, the via 526) includes: forming a fifth via (for example, the via 522) and a sixth via (for example, the via 538) that penetrate through the second insulation layer (for example, the insulating material 516) and the filler material (for example, the filler material 512), as shown in FIG. 9C; forming a fourth insulation layer (for example, the insulating material 524) on sidewalls and at bottoms of the second insulation layer (for example, the insulating material 516), the fifth via (for example, the via 522), and the sixth via (for example, the via 538), as shown in FIG. 5K; and respectively forming, at the fifth via (for example, the via 522) and the sixth via (for example, the via 538), a seventh via and an eighth via that penetrate through the fourth insulation layer (for example, the insulating material 524) and the first semiconductor layer (for example, the first semiconductor layer 514), where the fifth via (for example, the via 522) and the seventh via form the first via (for example, the via 526), and the sixth via (for example, the via 538) and the eighth via form a ninth via, as shown in FIG. 5L.

In some embodiments, the forming a conductive pillar (for example, the conductive pillar 530) includes: forming a fifth insulation layer (for example, the insulation layer 528) on a sidewall of the first via (for example, the via 526), as shown in FIG. 5M; and filling the first via (for example, the via 526) with a conductive material (for example, the conductive pillar 530), to form the conductive pillar (for example, the conductive pillar 530). For example, the conductive material may be formed by using an electrolytic plating process.

In some embodiments, a first end of the conductive pillar (for example, the conductive pillar 530) is interconnected with a contact of a first die (for example, the second die 540); and interconnecting a second end of the conductive pillar (for example, the conductive pillar 530) with a contact of the third semiconductor layer (for example, the third semiconductor layer 542).

In some embodiments, the forming a first via (for example, the via 526) includes: forming a tenth via (for example, the via 522) that penetrates through the second insulation layer (for example, the insulating material 516), the thermally conductive layer (for example, the graphene film 502), and the first insulation layer (for example, the insulating material 510), as shown in FIG. 8H; forming a sixth insulation layer (for example, the insulating material 524) on sidewalls and at bottoms of the second insulation layer (for example, the insulating material 516) and the tenth via (for example, the via 522), as shown in FIG. 5K; and forming, at the tenth via (for example, the via 522), an eleventh via that penetrates through the sixth insulation layer (for example, the insulating material 524) and the first semiconductor layer (for example, the first semiconductor layer 514), where the tenth via (for example, the via 522) and the eleventh via form the first via (for example, the via 526), as shown in FIG. 5L.

In some embodiments, the thermally conductive layer includes a first conductive pillar (for example, the conductive pillar 530 shown in FIG. 10H), the first semiconductor layer includes a second conductive pillar (for example, the conductive pillar 550 shown in FIG. 10H), and the forming a conductive pillar that penetrates through the first semiconductor layer and the thermally conductive layer includes: aligning and interconnecting the first conductive pillar with the second conductive pillar, as shown in FIG. 10H.

In some embodiments, the forming a first via (for example, the via 526) includes: forming a twelfth via (for example, the via 558) at the first semiconductor layer (for example, the first semiconductor layer 514), as shown in FIG. 11B; and forming, at the twelfth via (for example, the via 558), a thirteenth via that penetrates through the first insulation layer (for example, the insulating material 510), the thermally conductive layer (for example, the graphene film 502), and the second insulation layer (for example, the insulating material 516), where the twelfth via (for example, the via 558) and the thirteenth via form the first via (for example, the via 526), as shown in FIG. 11D.

Although the embodiments of the present invention and the advantages of the embodiments are described in detail, it should be understood that various modifications, replacements, and variations may be made to the present invention without departing from the spirit and scope of the present invention defined by the appended claims. In addition, the scope of this application is not intended to be limited to the specific embodiments of the processes, machine apparatuses, manufacturing, material composition, tools, methods, and steps in this specification. It is easily understood by a person skilled in the art from the present invention that according to the present invention, processes, machine apparatuses, manufacturing, material composition, tools, methods, or steps that are existing or to be developed in the future and that perform basically the same functions or achieve basically the same results as the corresponding embodiments of the present invention may be used. Therefore, the appended claims are intended to include the processes, machine apparatuses, manufacturing, material composition, tools, methods, or steps in the protection scope of the claims. In addition, each claim forms a separate embodiment, and combinations of the claims and the embodiments fall within the scope of the present invention.

## Claims

1. A semiconductor apparatus, comprising:
a first semiconductor layer;
a second die;
a thermally conductive layer, wherein the thermally conductive layer is stacked with the first semiconductor layer and the second die, is located between the first semiconductor layer and the second die, and is configured to conduct heat from the first semiconductor layer and/or heat from the second die at the thermally conductive layer, and a coefficient of thermal conductivity of the thermally conductive layer in a horizontal direction is greater than or equal to a coefficient of thermal conductivity in a vertical direction; and
a first conductive pillar, wherein the first conductive pillar penetrates through the thermally conductive layer, so that the first semiconductor layer and the second die are electrically interconnected by using the first conductive pillar, the first conductive pillar is electrically insulated from the thermally conductive layer, an extension direction of the first conductive pillar is the vertical direction, and the coefficient of thermal conductivity of the thermally conductive layer in the horizontal direction is greater than a coefficient of thermal conductivity of the first semiconductor layer.

2. The semiconductor apparatus according to claim 1, wherein there are a plurality of vias at the thermally conductive layer, and one or more first conductive pillars penetrate through one of the vias.

3. The semiconductor apparatus according to claim 1 or 2, wherein there is a bonding-based connection between the thermally conductive layer and the first semiconductor layer.

4. The semiconductor apparatus according to any one of claims 1 to 3, further comprising an insulating material, wherein the insulating material covers a surface of the thermally conductive layer, and the first conductive pillar further penetrates through the insulating material.

5. The semiconductor apparatus according to any one of claims 1 to 4, further comprising:
an insulation layer, wherein the insulation layer is disposed to at least partially surround the first conductive pillar and extend along the first conductive pillar and is configured to isolate the first conductive pillar from the thermally conductive layer to implement electrical insulation.

6. The semiconductor apparatus according to claim 5, further comprising:
a filler material, wherein the filler material is disposed at the thermally conductive layer and is located between the thermally conductive layer and the insulation layer.

7. The semiconductor apparatus according to claim 6, wherein the filler material is compatible with a through silicon via (TSV) process, and a through silicon via refers to an electrical interconnection implemented by filling a via of a silicon wafer with a conductive material.

8. The semiconductor apparatus according to any one of claims 1 to 7, wherein the first semiconductor layer is a first die or a first interconnection layer.

9. The semiconductor apparatus according to any one of claims 1 to 8, wherein the first semiconductor layer is the first die, the first conductive pillar further penetrates through the first die.

10. The semiconductor apparatus according to claim 9, further comprising:
a third semiconductor layer, wherein the third semiconductor layer is disposed on a side that is of the first semiconductor layer and is far away from the thermally conductive layer, and is electrically coupled to the conductive pillar.

11. The semiconductor apparatus according to any one of claims 1 to 10, wherein the thermally conductive layer comprises a carbon-based material, a metal material, or a combination thereof.

12. The semiconductor apparatus according to claim 11, wherein the carbon-based material comprises a graphene film.

13. The semiconductor apparatus according to claim 1, wherein a thickness of the thermally conductive layer is at least 5 µm.

14. An electronic device comprising the semiconductor apparatus according to any one of claims 1 to 13.

15. A heat spreader, comprising:
a carbon-based material layer, wherein a coefficient of thermal conductivity of the carbon-based material layer in a horizontal direction is greater than or equal to a coefficient of thermal conductivity in a vertical direction; and
a first non-metal pillar that penetrates through the carbon-based material layer, wherein an extension direction of the first non-metal pillar is the vertical direction, the first non-metal pillar is made of an insulating material or a semiconductor material, and a part that is of the first non-metal pillar and that is in contact with the carbon-based material layer is an insulating material.

16. The heat spreader according to claim 15, wherein surface roughness of a thermally conductive layer is less than or equal to 1 nm.

17. The heat spreader according to claim 15 or 16, wherein a diameter of the first non-metal pillar is between 10 µm and 40 µm.
